(19) Europäisches Patentamt

European Patent Office

Office européen des brevets

(11) **EP 4 742 541 A1**

(12) **EUROPEAN PATENT APPLICATION**
published in accordance with Art. 153(4) EPC

(43) Date of publication:
**13.05.2026 Bulletin 2026/20**

(21) Application number: **24851864.9**

(22) Date of filing: **06.08.2024**

(51) International Patent Classification (IPC):
*H03M 1/16* (2006.01)       *H03M 1/08* (2006.01)
*H03M 1/14* (2006.01)

(52) Cooperative Patent Classification (CPC):
**H03M 1/08; H03M 1/14; H03M 1/16**

(86) International application number:
**PCT/JP2024/028142**

(87) International publication number:
**WO 2025/033441 (13.02.2025 Gazette 2025/07)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **10.08.2023   JP 2023130891**

(71) Applicant: NATIONAL UNIVERSITY
CORPORATION
SHIZUOKA UNIVERSITY
Shizuoka-shi, Shizuoka 422-8529 (JP)

(72) Inventor: **KAWAHITO Shoji**
**Hamamatsu-shi, Shizuoka 432-8561 (JP)**

(74) Representative: **Wittmer, Maximilian**
**Grosse - Schumacher -
Knauer - von Hirschhausen
Patent- und Rechtsanwälte
Nymphenburger Straße 14
80335 München (DE)**

(54) **A/D CONVERTER AND A/D CONVERSION METHOD**

(57)     An A/D converter performs an A/D conversion including a folding integral. The A/D converter includes a gain stage that generates a calculation value based on an input value, and an A/D conversion circuit that outputs a calculation value that can be used to generate a digital value by comparing the calculation value generated by the gain stage with a conversion reference voltage. The gain stage generates a calculation value $V_O(M-1)$ using an integral gain $G(M-1)$ in the $(M-1)$_th integral operation among integral operations performed M times, and also generates a calculation value $V_O(M)$ using an integral gain $G(M)$ in the M_th integral operation. The integral gain $G(M-1)$ is greater than the integral gain $G(M)$.

*Fig.1*

Processed by Luminess, 75001 PARIS (FR)

## Description

### Technical Field

The present disclosure relates to an A/D converter and an A/D conversion method.

### Background Art

Patent Literature 1 to 6 disclose A/D converters that generate digital values from analog signals. For example, the A/D converters disclosed in Patent Literature 1 to 4 perform a folding integral type A/D conversion operation and a cyclic type A/D conversion operation by switching a switch. Specifically, the A/D converters first perform the folding integral type A/D conversion operation. Next, the A/D converters perform the cyclic type A/D conversion operation on an analog signal that is a calculation result of the folding integral type A/D conversion.

### Citation List

### Patent Literature

[Patent Literature 1] PCT International Publication No. WO2018-088476
[Patent Literature 2] Japanese Unexamined Patent Application No. 2017-201751
[Patent Literature 3] Japanese Unexamined Patent Application No. 2017-139583
[Patent Literature 4] PCT International Publication No. WO2012-111821
[Patent Literature 5] Japanese Unexamined Patent Application No. 2017-55174
[Patent Literature 6] Japanese Unexamined Patent Publication No. 2007-49637

### Summary of Invention

### Technical Problem

As in the A/D converters disclosed in Patent Literature 1 to 4, when the switching between the folding integral type and the cyclic type is performed by switching a switch, the calculation result (the analog signal) of the folding integral type which is an operation in a previous stage is kept within a range acceptable in the cyclic type which is an operation in a subsequent stage. Therefore, in the folding integral type operation, an integral gain is employed such that the calculation result of the integral operation is kept within a desired range.

The integral gain affects the effectiveness of noise reduction in the integral operation. As the integral gain increases, the effectiveness of noise reduction becomes higher. However, as the integral gain decreases, the effectiveness of noise reduction becomes lower. In other words, when it is necessary to keep the calculation result of the integral operation within the desired range, it becomes necessary to reduce the integral gain. As a result, the effectiveness of noise reduction is reduced.

The present disclosure describes an A/D converter and an A/D conversion method that can obtain a good effectiveness of noise reduction while the calculation result of integral operation is kept within a desired range.

### Solution to Problem

One aspect of the present disclosure is an A/D converter that performs an A/D conversion including a folding integral to obtain a digital value from an analog signal by repeatedly performing operations including sampling of an input signal and an integral of a sampled value. The A/D converter includes a gain stage configured to output a calculation value based on the analog signal, and an A/D conversion circuit configured to output a result that is usable to generate the digital value by comparing the calculation value output by the gain stage with a conversion reference voltage. The gain stage generates the calculation value based on the analog signal using a first integral gain in a k_th operation (k is an integer equal to or less than M-1) among the operations that are performed M times (M is an integer equal to or greater than 2). The gain stage generates the calculation value based on the analog signal using a second integral gain in a (k+1)_th operation. The second integral gain is smaller than the first integral gain.

The A/D converter makes the integral gain of the k_th integral operation, which corresponds to the next integral operation, smaller than the integral gain of the (k-1)_th integral operation among the plurality of integral operations. In other words, in order to keep the calculation value obtained by the M integral operations within the predetermined value, the A/D converter does not suppress the integral gain in all of the M integral operations, but suppresses the integral gain in the subsequent integral operations in which the calculation value becomes larger. As a result, a sufficient integral gain is obtained in the (k-1) _th integral operation or the like in which the integral gain is not suppressed. As a result, the effectiveness of noise reduction can be sufficiently ensured. The integral gain of the subsequent integral operation is suppressed. As a result, it is possible to prevent the calculation value obtained as a result of the M integral operations from being larger than a predetermined value. In other words, the A/D converter can obtain a good effectiveness of noise reduction while keeping the calculation result of the integral operation within a desired range.

In one aspect, the gain stage may generate the calculation value based on the analog signal using a third integral gain in a first operation. The third integral gain may be greater than the first integral gain. With such a configuration, it is possible to obtain an even better effectiveness of noise reduction.

In one aspect, the first integral gain may be used in the second to (M-1)_th operations. The second integral gain may be used in the M_th operation. With such a configuration, it is also possible to obtain an even better effectiveness of noise reduction.

In one aspect, the first integral gain may be 1 or more. The second integral gain may be 0 or more and less than 1. With such a configuration, it is also possible to obtain an even better effectiveness of noise reduction.

Another aspect of the present disclosure is an A/D converter that performs an A/D conversion including a folding integral to obtain a digital value from an analog signal by repeatedly performing operations including sampling of an input signal and an integral of a sampled value. The A/D converter according to another aspect includes a gain stage configured to output a calculation value based on the analog signal, and an A/D conversion circuit configured to output a result that is usable to generate the digital value by comparing the calculation value output by the gain stage with a conversion reference voltage. The gain stage includes a stage input configured to receive the analog signal, an operational amplifier circuit configured to generate the calculation value based on the analog signal, a stage output configured to output the calculation value to the A/D conversion circuit, a front stage capacitance part configured to be connectable to the stage input and an input of the operational amplifier circuit and including at least one front stage capacitor, and a feedback capacitance part configured to be connectable to the stage input and an output of the operational amplifier circuit and including one feedback capacitor. The gain stage selectively configures a first circuit and a second circuit different from the first circuit in the sampling of the input signal. The first circuit stores the analog signal in the at least one front stage capacitor by connecting the front stage capacitance part to the stage input, and stores the analog signal in the feedback capacitor by connecting the feedback capacitance part to the stage input, so that a ratio between a capacitance of the front stage capacitance part and a capacitance of the feedback capacitance part is set to the predetermined capacitance ratio. The second circuit stores the analog signal in the at least one front stage capacitor by connecting the front stage capacitance part to the stage input, and does not store the analog signal in the feedback capacitor by disconnecting the feedback capacitance part from the stage input, so that a ratio between the capacitance of the front stage capacitance part and the capacitance of the feedback capacitance part is a capacitance ratio that is smaller than the capacitance ratio in the first circuit.

Similar to the A/D converter according to one aspect of the present disclosure described above, this A/D converter can also obtain a good effectiveness of noise reduction while keeping the calculation results of the integral operations within the desired range.

In another aspect, the ratio between the capacitance of the front stage capacitance part and the capacitance of the feedback capacitance part may depend on a magnitude of the integral gain. With such a configuration, it is also possible to obtain an even better effectiveness of noise reduction.

In another aspect, the operations may be performed M times (M is an integer equal to or greater than 2). In the sampling of the input signal in the first operation, the first circuit may be used so that the ratio between the capacitance of the front stage capacitance part and the capacitance of the feedback capacitance part is set to the predetermined capacitance ratio. With such a configuration, it is also possible to obtain an even better effectiveness of noise reduction.

In another aspect, the operations may be performed M times (M is an integer equal to or greater than 2). In the sampling of the input signal in the second to (M-1)_th operations, the second circuit may be used so that the ratio between the capacitance of the front stage capacitance part and the capacitance of the feedback capacitance part is set to a capacitance ratio that is smaller than the predetermined capacitance ratio in the first circuit. With such a configuration, it is also possible to obtain an even better effectiveness of noise reduction.

In another aspect, the operations may be performed M times (M is an integer equal to or greater than 2).

In the sampling of the input signal in second to (M-1)_th operations, the number of the front stage capacitors that store the analog signal in the second circuit may be set to 2 or more, so that the ratio between the capacitance of the front stage capacitance part and the capacitance of the feedback capacitance part is set to a first capacitance ratio that is smaller than the predetermined capacitance ratio in the first circuit. In the sampling of the input signal in the M_th operation, the number of the front stage capacitors that store the analog signal in the second circuit may be set to 0 or 1, so that the ratio between the capacitance of the front stage capacitance part and the capacitance of the feedback capacitance part is set to a second capacitance ratio that is smaller than the first capacitance ratio. With such a configuration, it is also possible to obtain an even better effectiveness of noise reduction.

In another aspect, a capacitance of the feedback capacitor may be greater than a capacitance of the front stage capacitor. With such a configuration, it is also possible to obtain an even better effectiveness of noise reduction.

In another aspect, a capacitance of the feedback capacitor may be greater than a capacitance of the first front stage capacitor. The capacitance of the first front stage capacitor may be different from a capacitance of a second front stage capacitor different from the first front stage capacitor. With such a configuration, it is also possible to obtain an even better effectiveness of noise reduction.

Yet another aspect of the present disclosure is an A/D conversion method that performs an A/D conversion including a folding integral to obtain a digital value from an analog signal by repeatedly performing operations including sampling of an input signal and an integral of a sampled value. The A/D conversion method according to yet another aspect includes: generating a first calculation value based on the analog signal by performing the operations using a first integral gain; and generating a second calculation value based on the analog signal by performing the operations using a second integral gain after the generating of the first calculation value. The second integral gain is smaller than the first integral gain.

Similar to the A/D converter according to one aspect of the present disclosure described above, this A/D conversion method can also obtain a good effectiveness of noise reduction while keeping the calculation results of the integral operations within a desired range.

In yet another aspect, the method may further include generating a third calculation value based on the analog signal by performing the operations using a third integral gain before generating the first calculation value. The third integral gain may be greater than the first integral gain. With such a configuration, it is also possible to obtain an even better effectiveness of noise reduction.

In yet another aspect, the operations may be performed M times (M is an integer equal to or greater than 2). In the second to (M-1)_th operations, the generating of the first calculation value may be performed. In the M_th operation, the generating of the second calculation value may be performed. With such a configuration, it is also possible to obtain an even better effectiveness of noise reduction.

In yet another aspect, the first integral gain may be 1 or more, and the second integral gain may be 0 or more and less than 1. With such a configuration, it is also possible to obtain an even better effectiveness of noise reduction.

Yet another aspect of the present disclosure is an A/D conversion method that performs an A/D conversion including a folding integral to obtain a digital value from an analog signal by repeatedly performing operations including sampling of an input signal and an integral of a sampled value. The A/D conversion method according to yet another aspect includes a sampling step of the input signal for storing the analog signal at least in a front stage capacitance part, and an integration step of a sampled value for generating the calculation value at an output of an operational amplifier circuit by connecting at least the front stage capacitance part to an input of the operational amplifier circuit included in a gain stage, wherein the gain stage outputs a calculation value based on the analog signal, includes the front stage capacitance part having at least one front stage capacitor and a feedback capacitance part having one feedback capacitor, the front stage capacitance part is connectable to a stage input of the gain stage, and in the sampling step of the input signal, either a first storage or a second storage different from the first storage is performed. The first storage stores the analog signal in the at least one front stage capacitor by connecting the front stage capacitance part to the stage input and stores the analog signal in the feedback capacitor by connecting the feedback capacitance part to the stage input, so that a ratio between a capacitance of the front stage capacitance part and a capacitance of the feedback capacitance part is set to a predetermined capacitance ratio. The second storage stores the analog signal in the at least one front stage capacitor by connecting the front stage capacitance part to the stage input and does not store the analog signal in the feedback capacitance part by disconnecting the feedback capacitor from the stage input, so that the ratio between the capacitance of the front stage capacitance part and the capacitance of the feedback capacitance part is smaller than the predetermined capacitance ratio in the first storage.

Similar to the A/D converter according to one aspect of the present disclosure described above, this A/D conversion method can also obtain a good effectiveness of noise reduction while keeping the calculation results of the integral operations within a desired range.

In yet another aspect, the ratio between the capacitance of the front stage capacitance part and the capacitance of the feedback capacitance part may depend on a magnitude of the integral gain. With such a configuration, it is also possible to obtain an even better effectiveness of noise reduction.

In yet another aspect, the operations may be performed M times (M is an integer equal to or greater than 2). In the sampling step of the input signal in the first operation, the first storage may be performed so that the ratio between the capacitance of the front stage capacitance part and the capacitance of the feedback capacitance part is set to the predetermined capacitance ratio. With such a configuration, it is also possible to obtain an even better effectiveness of noise reduction.

In yet another aspect, the operations may be performed M times (M is an integer equal to or greater than 2). In the sampling step of the input signal in the second to (M-1)_th operations, the second storage may be performed so that the ratio between the capacitance of the front stage capacitance part and the capacitance of the feedback capacitance part is set to a capacitance ratio that is smaller than the predetermined capacitance ratio in the first storage. With such a configuration, it is also possible to obtain an even better effectiveness of noise reduction.

In yet another aspect, the operations may be performed M times (M is an integer equal to or greater than 2).

In the sampling of the input signal in the second to (M-1)_th operations, the number of the front stage capacitors that store the analog signal in the second storage may be set to 2 or more, so that the ratio between the capacitance of the front stage capacitance part and the capacitance of the feedback capacitance part is set to a first capacitance ratio that is smaller than the predetermined capacitance ratio in the first storage. In the sampling of the input signal in the M_th operation, the number of the front stage capacitors that store the analog signal in the second storage may be set to 0 or 1, so that the ratio between the capacitance of the front stage capacitance part and the capacitance of the feedback capacitance part is set to a second capacitance ratio that is smaller than the first capacitance ratio. With such a configuration, it is also possible to obtain an even better effectiveness of noise reduction.

**Advantageous Effects of Invention**

According to the present disclosure, an A/D converter and an A/D conversion method are described that can obtain a good noise reduction effect while the calculation results of the integral operations are kept within a desired range.

**Brief Description of Drawings**

FIG. 1 is a circuit diagram showing a configuration of an A/D converter according to a first embodiment.
FIG. 2 is a diagram for describing an integral gain in the operation of the A/D converter of FIG. 1.
FIGS. 3(a), 3(b), 3(c), 3(d), 3(e), and 3(f) are diagrams showing the operation of folding integral type A/D conversion in the A/D converter shown in FIG. 1.
FIG. 4 shows an example of input/output characteristics of the A/D converter.
FIGS. 5(a), 5(b), and 5(c) are diagrams showing the operation of cyclic type A/D conversion in the A/D converter shown in FIG. 1.
FIG. 6 is a circuit diagram showing a configuration of an A/D converter according to a second embodiment.
FIG. 7 is a diagram for describing the integral gain in an operation of the A/D converter of FIG. 6.
FIGS. 8(a), 8(b), 8(c), 8(d), 8(e), and 8(f) are diagrams showing an operation of the folding integral type A/D conversion in the A/D converter shown in FIG. 6.
FIGS. 9(a), 9(b), and 9(c) are diagrams showing an operation of the cyclic type A/D conversion in the A/D converter shown in FIG. 6.
FIG. 10 is a diagram for describing an integral gain in the operation of an A/D converter according to Modified example 1.
FIGS. 11(a), 11(b), 11(c), 11(d), 11(e), and 11(f) are diagrams showing an operation of the folding integral type A/D conversion in the A/D converter according to Modified example 1.
FIG. 12(a) is a diagram for describing an integral gain in the operation of an A/D converter according to Modified example 2. FIG. 12(b) is a diagram for describing an integral gain in the operation of an A/D converter according to Modified example 3.
FIG. 13 is a diagram showing a configuration of an image sensor cell.
FIG. 14(a) is a result of a first analysis example showing A/D conversion characteristics. FIG. 14(b) is a result of the first analysis example which shows non-linearity.
FIG. 15(a) is a result of a second analysis example which shows A/D conversion characteristics. FIG. 15(b) is a result of the second analysis example which shows non-linearity.
FIG. 16(a) is a result of a third analysis example which shows A/D conversion characteristics. FIG. 16(b) is a result of the third analysis example which shows non-linearity.

**Description of Embodiments**

The findings of the present disclosure can be readily understood by considering the following detailed description with reference to the accompanying drawings, which are shown as examples. Embodiments of an A/D converter and an A/D conversion method according to the present disclosure will be described below with reference to the accompanying drawings. Where possible, the same parts are given the same reference numerals and a repeated description thereof will be omitted.

EP 4 742 541 A1

<First embodiment>

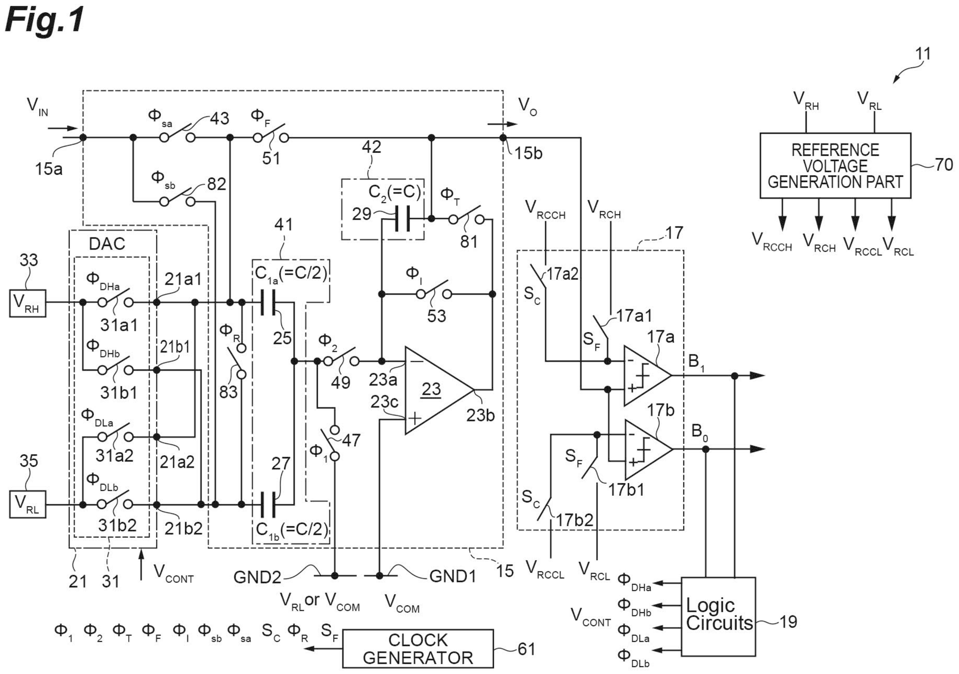

FIG. 1 is a circuit diagram of an A/D converter 11 according to an embodiment of the present disclosure. The A/D converter 11 performs a first A/D conversion operation which is a so-called folding integral type A/D conversion, and a second A/D conversion operation which is a cyclic type A/D conversion, using the same circuit configuration. The A/D converter 11 realizes the first A/D conversion operation and the second A/D conversion operation by changing a time-series control pattern for the switches included in the A/D converter 11.

As shown in FIG. 1, the A/D converter 11 includes a gain stage 15, an A/D conversion circuit 17, a logic circuit 19, a D/A conversion circuit 21, a clock generator 61, and a reference voltage generator 70.

The gain stage 15 includes an input 15a (stage input) that receives an input value $V_{IN}$ which is an analog signal to be converted to a digital value, and an output 15b (a stage output) that delivers a calculation value $V_O$. The gain stage 15 includes an operational amplifier circuit 23, a first capacitor 25 (a first front stage capacitor), a second capacitor 27 (a second front stage capacitor), and a third capacitor 29 (a feedback capacitor).

The operational amplifier circuit 23 includes a first input 23a, an output 23b, and a second input 23c. A phase of a signal delivered from the output 23b is inverted relative to a phase of a signal given to the first input 23a. For example, the first input 23a is an inverting input terminal. The second input 23c is a non-inverting input terminal. For example, the second input 23c of the operational amplifier circuit 23 is connected to a first standard potential GND1. The second input 23c receives a standard potential $V_{COM}$.

The first capacitor 25, the second capacitor 27, and the third capacitor 29 are capacitances for storage and calculation of various signal values.

The first capacitor 25 and the second capacitor 27 constitute a front stage capacitance part 41. The front stage capacitance part 41 can be connected to the input 15a by a plurality of switches 43, 82 and 83. The front stage capacitance part 41 can also be disconnected from the input 15a by the plurality of switches 43, 82 and 83. The front stage capacitance part 41 is also connected to the D/A conversion circuit 21.

The third capacitor 29 constitutes a feedback capacitance part 42. The feedback capacitance part 42 is connected to the input 23a of the operational amplifier circuit 23. The feedback capacitance part 42 can be connected to the input 15a by switches 43 and 51. The feedback capacitance part 42 can also be disconnected from the input 15a by the switches 43 and 51. The feedback capacitance part 42 can be connected to the output 23b of the operational amplifier circuit 23 by a switch 81. The feedback capacitance part 42 can also be disconnected from the output 23b of the operational amplifier circuit 23 by the switch 81.

A capacitance $C_2$ (a third capacitance) of the third capacitor 29 is greater than a capacitance $C_{1a}$ (a first capacitance) of the first capacitor 25. The capacitance $C_2$ (third capacitance) of the third capacitor 29 is greater than the capacitance $C_{1a}$ (first capacitance) of the first capacitor 25. Furthermore, the capacitance $C_2$ of the third capacitor 29 is greater than a capacitance $C_{1b}$ (a second capacitance) of the second capacitor 27. With the capacitances $C_{1a}$ and $C_{1b}$, the input value $V_{IN}$ input in the first A/D conversion operation which is a folding integral type A/D conversion is attenuated according to a capacitance ratio ($C_{1a}/C_2$, $C_{1b}/C_2$). Therefore, a voltage range of the calculation value $V_O$ output in the folding integral type A/D conversion becomes smaller according to the capacitance ratio of the capacitors. With such a configuration, a single-ended A/D converter 11 can be realized.

More specifically, the capacitance $C_2$ of the third capacitor 29 is twice the capacitance $C_{1a}$ of the first capacitor 25. The capacitance $C_2$ of the third capacitor 29 is twice the capacitance $C_{1b}$ of the second capacitor 27. The relationships $C_{1a}=1/2 \times C_2$ and $C_{1b}=1/2 \times C_2$ hold. According to the A/D converter 11 having such a capacitors, the input value $V_{IN}$ input in the folding integral type A/D conversion is attenuated by 1/2. The attenuated input value $V_{IN}$ is sampled and integrated. Therefore, the voltage range of the calculation value $V_O$, which is an analog signal output in the folding integral type A/D conversion, is halved in accordance with the capacitance ratio of the capacitors. Thus, in the second A/D conversion operation which is the cyclic type A/D conversion, an input voltage suitable for the single-ended A/D converter is provided.

The gain stage 15 includes a plurality of switches 43, 47, 49, 51, 53, 81, 82 and 83. These switches connect the input 15a of the gain stage 15 to, or disconnect it from, the first capacitor 25, the second capacitor 27, and the third capacitor 29. These switches connect the first capacitor 25, the second capacitor 27, and the third capacitor 29 to, or disconnect them from, the operational amplifier circuit 23. The arrangement of the switches 43, 47, 49, 51, 53, 81, 82 and 83 shown in FIG. 1 is an example. The switches 43, 47, 49, 51, 53, 81, 82 and 83 are controlled by control signals $\varphi_{sa}$, $\varphi_{sb}$, $\varphi_1$, $\varphi_2$, $\varphi_F$, $\varphi_I$, $\varphi_T$, and $\varphi_R$ generated by the clock generator 61.

The A/D converter 11 repeats the integral operation from the first time to the M_th time. In these integral operations, the gain stage 15 outputs a value obtained by multiplying the input value $V_{IN}$ by a predetermined integral gain as the calculation value $V_O$. The integral gain in each of the integral operations is denoted as G(k). The letter "k" in parentheses means the number of integral operations (the number of cycles), where k is an integer from 1 to M. These integral gains G(k) are not constant. For example, the integral gains G(k) may be set as follows.

Integral gain G(1) = 1.5 (a third integral gain)

6

Integral gain G(2) to G(M-1) = 1.0 (a first integral gain)
Integral gain G(M) = 0.5 (a second integral gain)

The integral gain G(1) of the first integral operation is the largest. The integral gain G(M) of the M_th (last) integral operation is the smallest. The integral gains G(2) to G(M-1) for the second to (M-1)th integral operations are constant. The integral gain G is determined by the configuration of the capacitor that store the input value $V_{IN}$. The capacitor that stores the input value $V_{IN}$ can be selected by a plurality of switches included in the gain stage 15. Specific operations will be described in detail below.

The A/D conversion circuit 17 generates a digital value D based on the calculation value $V_O$ provided from the output 15b of the gain stage 15 in accordance with a first conversion reference voltage $V_{RCH}$ and/or a second conversion reference voltage $V_{RCL}$.

The A/D conversion circuit 17 includes a comparator 17a (a first comparator) and a comparator 17b (a second comparator). The A/D conversion circuit 17 generates a 1.5-bit digital value D using both the comparators 17a and 17b. The digital value D indicates an A/D conversion value. The A/D conversion circuit 17 may generate a 1-bit digital value D using either the comparator 17a or 17b.

A first input of the comparator 17a is connected to the output 15b of the gain stage 15. The first input of the comparator 17a receives the calculation value $V_O$ from the gain stage 15. A second input of the comparator 17a is connected to the reference voltage generation part 70 via switches 17a1 and 17a2. The second input of the comparator 17a receives either a first conversion reference voltage $V_{RCH}$ or a first conversion reference voltage $V_{RCCH}$ from the reference voltage generation part 70 which will be described below under the control of the switches 17a1 and 17a2. The switches 17a1 and 17a2 are controlled by control signals $S_F$ and $S_C$ output from the clock generator 61.

During the folding integral type A/D conversion operation, the comparator 17a receives the first conversion reference voltage $V_{RCH}$. At this time, the switch 17a1 is conductive and the switch 17a2 is nonconductive. During the cyclic type A/D conversion operation, the comparator 17a receives the first conversion reference voltage $V_{RCCH}$. At this time, the switch 17a2 is conductive and the switch 17a1 is nonconductive. The comparator 17a compares the calculation value $V_O$ with the first conversion reference voltage $V_{RCH}$ or compares the calculation value $V_O$ with the first conversion reference voltage $V_{RCCH}$ to generate a bit ($B_1$) that is a comparison result signal.

In the comparator 17a, the input to which the first conversion reference voltage $V_{RCH}$ is provided may be connected to a standard potential $V_{COM}$ via a capacitor (not shown). Such a configuration allows high-frequency noise filtering.

A first input of the comparator 17b is connected to the output 15b of the gain stage 15. The first input of the comparator 17b receives the calculation value $V_O$. A second input of the comparator 17b is connected to the reference voltage generation part 70 via switches 17b1 and 17b2. The second input of the comparator 17a receives either a second conversion reference voltage $V_{RCL}$ or a second conversion reference voltage $V_{RCCL}$ from the reference voltage generation part 70, which will be described below, under control of the switches 17b1 and 17b2. The switches 17b1 and 17b2 are controlled by control signals $S_F$ and $S_C$ output from the clock generator 61.

During the folding integral type A/D conversion operation, the comparator 17b receives the second conversion reference voltage $V_{RCL}$. At this time, the switch 17b1 is conductive and the switch 17b2 is nonconductive. During the cyclic type A/D conversion operation, the comparator 17b receives the second conversion reference voltage $V_{RCCL}$. At this time, the switch 17b2 is conductive and the switch 17b1 is nonconductive. The comparator 17b compares the calculation value VO with the second conversion reference voltage VRCL or the second conversion reference voltage VRCCL to generate a bit (B0) that is a comparison result signal.

When the A/D conversion circuit 17 generates a 1.5-bit digital value D, the digital value D for one integral operation or each cycle can take three values (D=0, D=1, D=2) due to a combination of bits ($B_0$ and $B_1$). In this case, the comparators 17a and 17b operate as follows.

When

$$V_O > V_{RCH}, \ D=2 \ (B_1=1, \ B_0=1)$$

When

$$V_{RCL} < V_O \leq V_{RCH}, \ D=1 \ (B_1=0, \ B_0=1)$$

When

$$V_O \leq V_{RCL}, \ D=0 \ (B_1=0, \ B_0=0)$$

When the A/D conversion circuit 17 generates a 1-bit digital value D, the digital value D for one integral operation or each cycle can take two values (D=0 or D=1) according to the value of the bit ($B_1$). At this time, the comparator 17a operates in the A/D conversion circuit 17. Therefore, the signal used as a reference when the 1-bit digital value D is generated is the first conversion reference voltage $V_{RCH}$. In this case, the comparator 17a operates as follows.

When

$$V_O \geq V_{RCH}, \ B_1 = 1$$

When

$$V_O < V_{RCH}, \ B_1 = 0$$

The reference voltage generation part 70 is connected to standard voltage sources 33 and 35. The reference voltage generation part 70 receives a standard reference voltage $V_{RH}$ from the standard voltage source 33. Further, the reference voltage generation part 70 receives a standard reference voltage $V_{RL}$ from the standard voltage source 35. The reference voltage generation part 70 is connected to the A/D conversion circuit 17. The reference voltage generation part 70 outputs the first conversion reference voltages $V_{RCH}$ and $V_{RCCH}$ to the comparator 17a of the A/D conversion circuit 17. The reference voltage generation part 70 outputs the second conversion reference voltages $V_{RCL}$ and $V_{RCCL}$ to the comparator 17b of the A/D conversion circuit 17. The first conversion reference voltage $V_{RCH}$ and the second conversion reference voltage $V_{RCL}$ are used for the folding integral type A/D conversion operation. The first conversion reference voltage $V_{RCCH}$ and the second conversion reference voltage $V_{RCCL}$ are used for the cyclic type A/D conversion operation.

Each of the first conversion reference voltages $V_{RCH}$ and $V_{RCCH}$ and the second conversion reference voltages $V_{RCL}$ and $V_{RCCL}$ may be set to a fixed value. Furthermore, the first conversion reference voltages $V_{RCH}$ and $V_{RCCH}$ and the second conversion reference voltages $V_{RCL}$ and $V_{RCCL}$ may be variable values. For example, in the folding integral type A/D conversion operation, the reference voltage generation part 70 may control the first conversion reference voltage $V_{RCH}$ and the second conversion reference voltage $V_{RCL}$ in accordance with the input value $V_{IN}$ received by the input 15a of the gain stage 15. Additionally, the reference voltage generation part 70 may control the first conversion reference voltage $V_{RCH}$ and the second conversion reference voltage $V_{RCL}$ in accordance with the calculation value $V_O$ generated at the output 15b of the gain stage 15.

The logic circuit 19 is connected to the D/A conversion circuit 21. The logic circuit 19 outputs a control signal $V_{CONT}$ to the D/A conversion circuit 21. The logic circuit 19 is connected to the outputs of the comparators 17a and 17b. The logic circuit 19 receives the calculation value $B_1$ from the comparator 17a and the calculation value $B_0$ from the comparator 17b. The logic circuit 19 can generate the control signal $V_{CONT}$ (for example, $\varphi_{DHa}$, $\varphi_{DHb}$, $\varphi_{DLa}$, $\varphi_{DLb}$) corresponding to the digital value D.

The D/A conversion circuit 21 receives a first standard reference voltage $V_{RH}$ and a second standard reference voltage $V_{RL}$ from the standard voltage sources 33 and 35. The D/A conversion circuit 21 outputs the first standard reference voltage $V_{RH}$ and the second standard reference voltage $V_{RL}$ to the gain stage 15 in accordance with the control signal $V_{CONT}$. The D/A conversion circuit 21 includes four outputs 21a1, 21a2, 21b1 and 21b2, and a switch circuit 31.

The output 21a1 is connected to the first capacitor 25. The output 21al outputs the first standard reference voltage $V_{RH}$ to the first capacitor 25 in accordance with the control signal $\varphi_{DHa}$. The output 21b1 is connected to the second capacitor 27. The output 21b1 outputs the first standard reference voltage $V_{RH}$ to the second capacitor 27 in accordance with the control signal $\varphi_{DHb}$. The output 21a2 is connected to the first capacitor 25. The output 21a2 outputs the second standard reference voltage $V_{RL}$ to the first capacitor 25 in accordance with the control signal $\varphi_{DLa}$. The output 21b2 is connected to the second capacitor 27. The output 21b2 outputs the second standard reference voltage $V_{RL}$ to the second capacitor 27 in accordance with the control signal $\varphi_{DLb}$.

The switch circuit 31 includes switches 31a1, 31a2, 31b1 and 31b2. The switch 31a1 is connected to the output 21a1 and controls provision of the first standard reference voltage $V_{RH}$ to the output 21a1 in accordance with the control signal $\varphi_{DHa}$. The switch 31b1 is connected to the output 21b1 and controls provision of the first standard reference voltage $V_{RH}$ to the output 21b1 in accordance with the control signal $\varphi_{DHb}$. The switch 31a2 is connected to the output 21a2 and controls provision of the second standard reference voltage $V_{RL}$ to the output 21a2 in accordance with the control signal $\varphi_{DLa}$. The switch 31b2 is connected to the output 21b2 and controls provision of the second standard reference voltage $V_{RL}$ to the output 21b2 in accordance with the control signal $\varphi_{DLb}$.

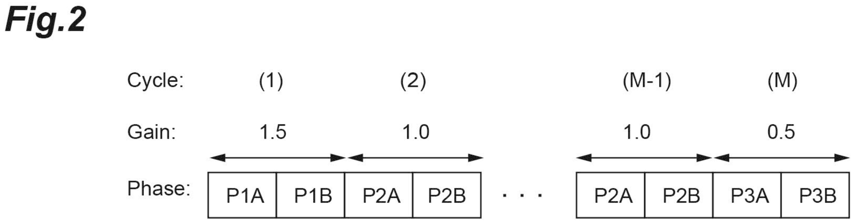

Next, the first A/D conversion operation in the A/D converter 11 shown in FIG. 1 is described. The first A/D conversion operation is a folding integral type operation to obtain an output value that is the digital value D from the input value $V_{IN}$ that is an analog value by repeatedly sampling an input signal and integrating a sampled value. As shown in FIG. 2, the folding integral type operation includes a first storage operation P1A, a first calculation operation P1B, a second storage operation P2A, a second calculation operation P2B, a third storage operation P3A, and a third calculation operation P3B.

First, the A/D converter 11 performs the first storage operation P1A and the first calculation operation P1B. The first storage operation P1A and the first calculation operation P1B correspond to the first integral operation (k=1) among the integral operations that are performed M times. The integral gain G(1) in the first storage operation P1A and the first calculation operation P1B is 1.5.

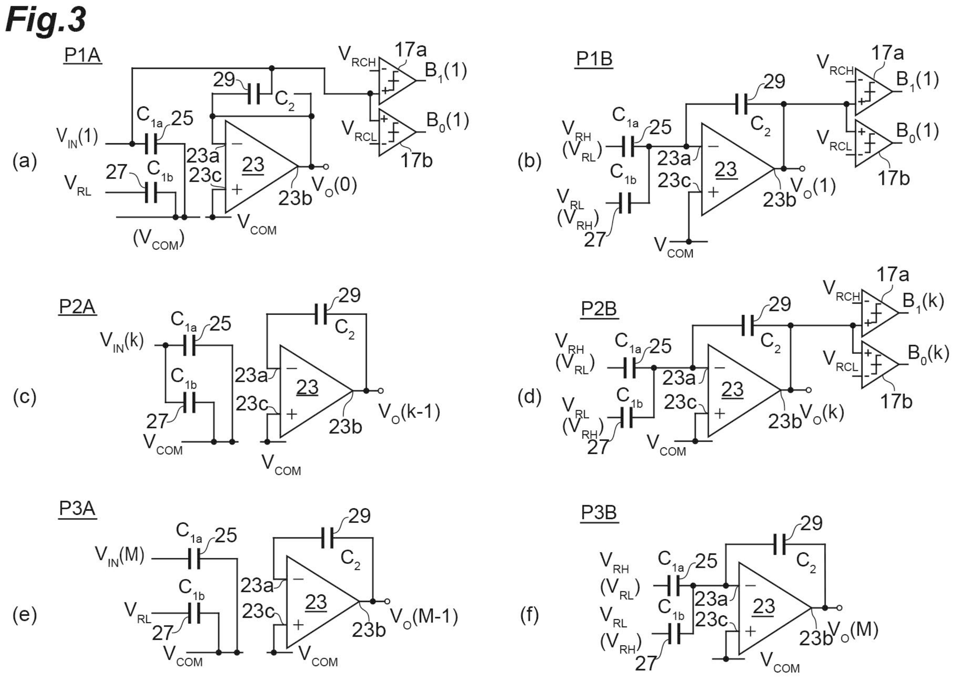

The A/D converter 11 performs the first storage operation P1A. FIG. 3(a) shows a circuit configuration in the first storage operation P1A. This circuit configuration is realized by control signals ($\varphi_{DHa}=0$, $\varphi_{DHb}=0$, $\varphi_{DLa}=0$, $\varphi_{DLb}=1$) and control signals ($\varphi_{sa}=1$, $\varphi_{sb}=0$, $\varphi_1=1$, $\varphi_2=0$, $\varphi_F=1$, $\varphi_I=1$, $\varphi_T=0$, $\varphi_R=0$, $S_F=1$, $S_C=0$) output from the clock generator 61.

According to the circuit configuration in FIG. 3(a), the first capacitor 25 is connected to the input 15a of the gain stage 15 and a second standard potential GND2. As a result, the first capacitor 25 receives the input value $V_{IN}$. The second capacitor 27 is connected to the output 21b2 of the D/A conversion circuit 21 and the second standard potential GND2. As a result, the second capacitor 27 receives the second standard reference voltage $V_{RL}$. The third capacitor 29 is connected to the input 15a of the gain stage 15 and the operational amplifier circuit 23. Specifically, one end portion of the third capacitor 29 is connected to the first input 23a and the output 23b of the operational amplifier circuit 23. As a result, the third capacitor 29 receives the input value $V_{IN}$. That is, when the integral gain G is set to 1.5, charge corresponding to the input value $V_{IN}$ is stored in the first capacitor 25 and the third capacitor 29.

Following the first storage operation P1A, the A/D converter 11 performs the first calculation operation P1B (refer to FIG. 2). FIG. 3(b) shows a circuit configuration in the first calculation operation P1B. This circuit configuration is realized by control signals ($\varphi_{DHa}=1$, $\varphi_{DHb}=0$, $\varphi_{DLa}=0$, $\varphi_{DLb}=1$) and control signals ($\varphi_{sa}=0$, $\varphi_{sb}=0$, $\varphi_1=0$, $\varphi_2=1$, $\varphi_F=0$, $\varphi_I=0$, $\varphi_T=1$, $\varphi_R=0$, $S_F=1$, $S_C=0$) output from the clock generator 61.

According to the circuit configuration in FIG. 3(b), the first capacitor 25 is connected to the output 21a1 of the D/A conversion circuit 21 and the first input 23a of the operational amplifier circuit 23. As a result, the first capacitor 25 receives the first standard reference voltage $V_{RH}$. The second capacitor 27 is connected to the output 21b2 of the D/A conversion circuit 21 and the first input 23a of the operational amplifier circuit 23. As a result, the second capacitor 27 receives the second standard reference voltage $V_{RL}$. The third capacitor 29 is connected between the first input 23a and the output 23b of the operational amplifier circuit 23.

In addition, the comparator 17a receives the first conversion reference voltage $V_{RCH}$. The comparator 17a compares the calculation value $V_O(1)$ with the first conversion reference voltage $V_{RCH}$ and outputs a calculation value $B_1(1)$ in accordance with a comparison result. In addition, the comparator 17b receives the second conversion reference voltage $V_{RCL}$. The comparator 17b compares the calculation value $V_O(1)$ with the second conversion reference voltage $V_{RCL}$ and outputs a calculation value $B_0(1)$ in accordance with a comparison result.

Specifically, the output (the digital value D) of the A/D conversion circuit 17 is as follows

[Math. 1]

$$D(1) = \begin{cases} 0 & (V_{IN}(1) < V_{RCL}) \\ 1 & (V_{RCL} \leq V_{IN}(1) < V_{RCH}) \cdots \ (1) \\ 2 & (V_{RCH} \leq V_{IN}(1)) \end{cases}$$

According to the connection configuration, the calculation value $V_O(1)$ is generated at the output 23b of the operational amplifier circuit 23.

[Math. 2]

$$V_O(1) = 1.5V_{IN}(1) + 0.5V_{RL} - V_R(1) \cdots \ (2)$$

[Math. 3]

$$V_R(1) = \begin{cases} V_{RH} & (D(1) = 2) \\ \dfrac{V_{RH} + V_{RL}}{2} & (D(1) = 1) \cdots \ (3) \\ V_{RL} & (D(1) = 0) \end{cases}$$

Then, the A/D converter 11 alternately performs the second storage operation P2A and the second calculation operation P2B multiple times (refer to FIG. 2). The second storage operation P2A and the second calculation operation P2B correspond to the second to (M-1)_th integral operations among the integral operations performed M times. The integral gains G(2) to G(M-1) in the second storage operation P2A and the second calculation operation P2B are 1.0. In other words, the integral gains G(2) to G(M-1) are smaller than the integral gain G(1).

FIG. 3(c) shows a circuit configuration in the second storage operation P2A. This circuit configuration is realized by control signals ($\varphi_{DHa}$ = 0, $\varphi_{DHb}$ = 0, $\varphi_{DLa}$=0, $\varphi_{DLb}$=0) and control signals ($\varphi_{sa}$=1, $\varphi_{sb}$=1, $\varphi_1$=1, $\varphi_2$=0, $\varphi_F$=0, $\varphi_I$=0, $\varphi_T$=1, $\varphi_R$=0, $S_F$=1, $S_C$=0) output from the clock generator 61.

According to the circuit configuration in FIG. 3(c), the first capacitor 25 is connected to the input 15a of the gain stage 15 and the second standard potential GND2. As a result, the first capacitor 25 receives the input value $V_{IN}$. The second capacitor 27 is connected to the input 15a of the gain stage 15 and the second standard potential GND2. As a result, the second capacitor 27 receives the input value $V_{IN}$. The third capacitor 29 is connected to the first input 23a of the operational amplifier circuit 23 and the output 23b of the operational amplifier circuit 23. That is, when the integral gain G is set to 1.0, the input value $V_{IN}$ is stored in the first capacitor 25 and the second capacitor 27.

Following the second storage operation P2A, the A/D converter 11 performs the second calculation operation P2B. As shown in FIG. 3(d), the second calculation operation P2B is performed with the same circuit configuration as the first calculation operation P1B described above (refer to FIG. 3(b)). Therefore, a detailed description of the second calculation operation P2B will be omitted.

In the second calculation operation P2B, the output of the A/D conversion circuit 17 is as follows:

[Math. 4]

$$D(k) = \begin{cases} 0 & (V_o(k-1) < V_{RCL}) \\ 1 & (V_{RCL} \leq V_o(k-1) < V_{RCH}) \cdots \ (4) \\ 2 & (V_{RCH} \leq V_o(k-1)) \end{cases}$$

According to this connection configuration, a calculation value $V_O(k)$ is generated at the output 23b of the operational amplifier circuit 23.

[Math. 5]

$$V_o(k) = V_o(k-1) + V_{IN}(k) - V_R(k) \cdots \ (5)$$

[Math. 6]

$$V_R(k) = \begin{cases} V_{RH} & (D(k) = 2) \\ \dfrac{V_{RH} + V_{RL}}{2} & (D(k) = 1) \cdots \ (6) \\ V_{RL} & (D(k) = 0) \end{cases}$$

Furthermore, in the first calculation operation P1B, the second calculation operation P2B, and the third calculation operation P3B described below, for example, the second standard reference voltage $V_{RL}$ may be provided to the first capacitor 25, and the first standard reference voltage $V_{RH}$ may be provided to the second capacitor 27. Then, when the second calculation operation P2B in which the integral gain G is 1.0 is repeated multiple times, a first circuit configuration in which the first standard reference voltage $V_{RH}$ is provided to the first capacitor 25 and the second standard reference voltage $V_{RL}$ is provided to the second capacitor 27 and a second circuit configuration in which the second standard reference voltage $V_{RL}$ is provided to the first capacitor 25 and the first standard reference voltage $V_{RH}$ is provided to the second capacitor 27 may be alternately performed.

Next, the A/D converter 11 performs the third storage operation P3A and the third calculation operation P3B. The third storage operation P3A and the third calculation operation P3B correspond to the M_th integral operation among the integral operations performed M times. The integral gain G(M) in the third storage operation P3A and the third calculation operation P3B is 0.5. That is, the integral gain G(M)=0.5 is smaller than the integral gain G(1)=1.5. Furthermore, the integral gain G(M)=0.5 is smaller than the integral gains G(2) to G(M-1)=1.0.

FIG. 3(e) shows a circuit configuration in the third storage operation P3A. The circuit configuration is realized by control signals ($\varphi_{DHa}$=0, $\varphi_{DHb}$=0, $\varphi_{DLa}$=0, $\varphi_{DLb}$=1) and control signals ($\varphi_{sa}$=1, $\varphi_{sb}$=0, $\varphi_1$=1, $\varphi_2$=0, $\varphi_F$=0, $\varphi_I$=0, $\varphi_T$=1, $\varphi_R$=0,

$S_F$=1, $S_C$=0) output from the clock generator 61.

According to the circuit configuration in FIG. 3(e), the first capacitor 25 is connected to the input 15a of the gain stage 15 and the second standard potential GND2. As a result, the first capacitor 25 receives the input value $V_{IN}$. The second capacitor 27 is connected to the output 21b2 of the D/A conversion circuit 21 and the second standard potential GND2. As a result, the second capacitor 27 receives the second standard reference voltage $V_{RL}$. The third capacitor 29 is connected to the first input 23a of the operational amplifier circuit 23 and the output 23b of the operational amplifier circuit 23. That is, when the integral gain G is set to 0.5, the input value $V_{IN}$ is stored only in the first capacitor 25.

Next, following the third storage operation P3A, the A/D converter 11 performs the third calculation operation P3B. As shown in FIG. 3(f), the third calculation operation P3B is performed by the same configuration as the first calculation operation P1B described above. Therefore, a detailed description of the third calculation operation P3B will be omitted.

In the third calculation operation P3B, the output of the A/D conversion circuit 17 is as follows

[Math. 7]

$$D(M) = \begin{cases} 0 & (V_O(M-1) < V_{RCL}) \\ 1 & (V_{RCL} \leq V_O(M-1) < V_{RCH}) \cdots (7) \\ 2 & (V_{RCH} \leq V_O(M-1)) \end{cases}$$

According to the connection configuration, a calculation value $V_O(M)$ is generated at the output 23b of the operational amplifier circuit 23.

[Math. 8]

$$V_O(M) = V_O(M-1) + 0.5V_{IN}(M) + 0.5V_{RL} - V_R(M) \cdots (8)$$

[Math. 9]

$$V_R(M) = \begin{cases} V_{RH} & (D(M) = 2) \\ \dfrac{V_{RH} + V_{RL}}{2} & (D(M) = 1) \cdots (9) \\ V_{RL} & (D(M) = 0) \end{cases}$$

Incidentally, when two types of conversion reference voltages, $V_{RCH}$ and $V_{RCL}$, are used, A/D conversion of $\log_2$ (2M) bits is possible by performing integral operations M times. For example, for an input value $V_{IN}$ having an amplitude of 1V, the amplitude of the calculation value $V_O$ can become 1.5 V, which can exceed 1.0 V, the allowable input range of the subsequent cyclic stage. In this case, the integral gain G is reduced by reducing the capacitance of the capacitor that stores the input value $V_{IN}$. This reduction of the integral gain G allows the amplitude of the calculation value $V_O$ to be kept within a desired range. However, suppression of the integral gain G creates two issues.

A first issue is a reduction in the number of output bits. When the first conversion reference voltage $V_{RCH}$ and the second conversion reference voltage $V_{RCL}$ are used, in principle, M integrals will result in 2M (more precisely, 2M-2 or 2M-3) foldbacks occurring. However, in order to prevent the integral from diverging, when the amplitude of the input is 1 V, an integral voltage when no foldback is performed (1×M×G) must be equal to the sum of foldback voltages (2×M×$V_R$). That is, $V_R$=(1×M×G)/(2×M)=0.5×G. However, because it is necessary to share the circuit with the subsequent cyclic type A/D converter, the relationship $V_R$=G holds, and so the number of foldbacks n=(M×G)/$V_R$=(M × G)/G=M($\log_2$(M) bits), which results in a resolution that is 1 bit less than the number of bits that would otherwise be obtained, $\log_2$(2M).

A second issue is the degradation of noise reduction performance. By setting the integral gain to 1/2, the noise reduction performance by integration is reduced to 1/√2.

Therefore, the A/D converter 11 reduces the number of capacitors that store analog signals in the k_th integral operation, which corresponds to a next integral operation, which is the next integral operation, smaller than the number of capacitors that store the analog signal in the (k-1)_th integral operation among the multiple integral operations. With this configuration, it is possible to make the k_th integral gain G, which corresponds to the next integral operation, smaller than the (k-1)_th integral gain G among the multiple integral operations. In other words, the capacitance of the capacitor that stores the input value $V_{IN}$ is not kept constant during the multiple integral operations, but varies according to the number of integral operations. In order to keep the calculation value $V_O$ obtained by the M integral operations within a predetermined value, it is possible to suppress the integral gain G for the subsequent integral operation in which the calculation value $V_O$ becomes large without suppressing the integral gain G for all of the M integral operations. As a result, in the integral operation such as the (k-1)_th operation in which the integral gain G is not suppressed, a sufficient integral gain G is obtained, and thus a good effectiveness of noise reduction can be sufficiently ensured. On the other hand, since the integral gain G is suppressed for the subsequent integral operation, it is possible to prevent the calculation value $V_O$ obtained as a result of the M integral operations from becoming larger than the predetermined value.

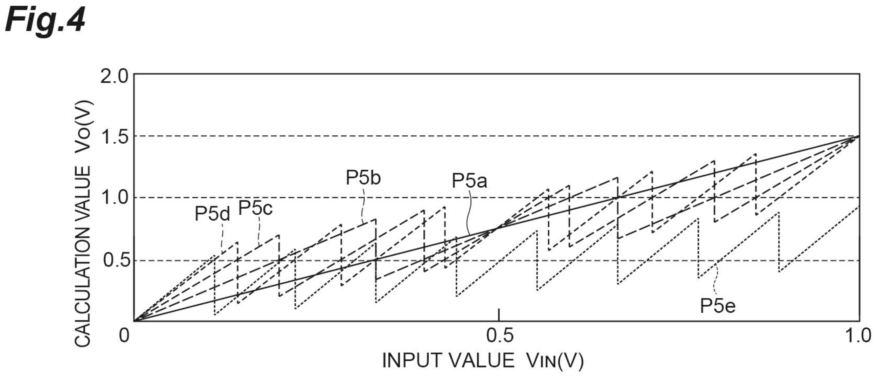

For example, FIG. 4 shows an example of conversion characteristics of the A/D converter 11. In this example, the number of integrals is set to 5 (M=5), the integral gains G(k) are set such that G(1)=1.5, G(2)=1.0, G(3)=1.0, G(4)=1.0, and G(5)=0.5, the first conversion reference voltage $V_{RCH}$ is set to 1.0 V, and the second conversion reference voltage $V_{RCL}$ is set to 0.5 V. Graph P5a corresponds to the first integral operation, graph P5b corresponds to the second integral operation, graph P5c corresponds to the third integral operation, graph P5d corresponds to the fourth integral operation, and graph P5e corresponds to the fifth integral operation. In particular, as shown in graph P5e, the calculation value $V_O$ can be kept within the desired range (here, 1.0 V) even in the fifth integral operation. Therefore, the A/D converter 11 of this embodiment can obtain a good effectiveness of noise reduction and high resolution while keeping the calculation results of the integral operations within the desired range.

In short, in the A/D converter 11 using a folding integral used in an image sensor, the integral gain G is made variable in the multiple integral operations. As a result, according to the A/D converter 11 of the first embodiment, the resolution can be increased by 1 bit and the integral gain can be doubled (S/N is $\sqrt{2}$ times). Therefore, the A/D converter 11 of the first embodiment has high resolution and low noise.

Next, the second A/D conversion operation in the A/D converter 11 shown in FIG. 1 will be described. The second A/D conversion operation is a cyclic type A/D conversion operation Y. The cyclic type A/D conversion operation Y in the A/D converter 11 is described below.

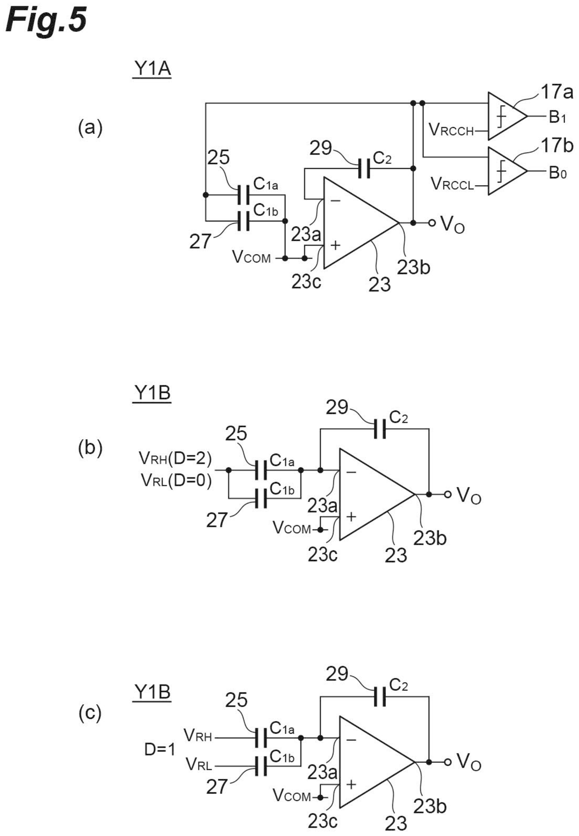

FIGS. 5(a), 5(b) and 5(c) are circuit diagrams for describing the second A/D conversion operation. In the second A/D conversion operation, the A/D conversion circuit 17 generates the digital value D using two comparators 17a and 17b.

First, the gain stage 15 performs a second initial storage operation Y1A, as shown in FIG. 5(a). In the second initial storage operation Y1A, the calculation value $V_O(M)$ in the folding integral type A/D conversion operation P is stored in the first capacitor 25, the second capacitor 27, and the third capacitor 29. In the second initial storage operation Y1A, the gain stage 15 receives control signals ($\varphi_{sa}$=0, $\varphi_{sb}$=0, $\varphi_1$=1, $\varphi_2$=0, $\varphi_F$=1, $\varphi_I$=0, $\varphi_T$=1, $\varphi_R$=1, $S_F$=0, $S_C$=1). The D/A conversion circuit 21 also receives control signals ($\varphi_{DHa}$=0, $\varphi_{DHb}$=0, $\varphi_{DLa}$=0, $\varphi_{DLb}$=0). Further, in the second initial storage operation Y1A, the calculation value $V_O(M)$ in the folding integral type A/D conversion operation is provided to the comparators 17a and 17b. The comparators 17a and 17b generate a digital value D based on the provided calculation value $V_O(M)$.

Subsequently, following the second initial storage operation Y1A, the gain stage 15 performs a second calculation operation Y1B according to the digital value D ($=B_1+B_0$), as shown in FIG. 5(b) or 5(c). In the second calculation operation Y1B, the gain stage 15 generates the calculation value $V_O$ using the operational amplifier circuit 23, the first capacitor 25, the second capacitor 27, and the third capacitor 29.

In the second calculation operation Y1B, the gain stage 15 receives control signals ($\varphi_{sa}$=0, $\varphi_{sb}$=0, $\varphi_1$=0, $\varphi_2$=1, $\varphi_F$=0, $\varphi_I$=0, $\varphi_T$=1, $\varphi_R$=0, $S_F$=0, $S_C$=1). In the second calculation operation Y1B, the third capacitor 29 is connected between the output 23b and the first input 23a of the operational amplifier circuit 23. The first capacitor 25 and the second capacitor 27 are connected to the D/A conversion circuit 21, and the voltages provided to the first capacitor 25 and the second capacitor 27 are controlled according to the digital value D ($=B_1+B_0$).

When D=2, the switch circuit 31 receives control signals ($\varphi_{DHa}$=1, $\varphi_{DHb}$=1, $\varphi_{DLa}$=0, $\varphi_{DLb}$=0). As a result, when D=2, the first standard reference voltage $V_{RH}$ is provided to the outputs 21a1 and 21b1 of the D/A conversion circuit 21. In this case, each of the first capacitor 25 and the second capacitor 27 receives the first standard reference voltage $V_{RH}$.

When D=0, the switch circuit 31 receives control signals ($\varphi_{DHa}$=0, $\varphi_{DHb}$=0, $\varphi_{DLa}$=1, $\varphi_{DLb}$=1). As a result, when D=0, the second standard reference voltage $V_{RL}$ is provided to the output 21a2 and the output 21b2 of the D/A conversion circuit 21. In this case, each of the first capacitor 25 and the second capacitor 27 receives the second standard reference voltage $V_{RL}$.

When D=1, the switch circuit 31 receives control signals ($\varphi_{DHa}$=1, $\varphi_{DHb}$=0, $\varphi_{DLa}$=0, $\varphi_{DLb}$=1). As a result, when D=1, the first standard reference voltage $V_{RH}$ is provided to the output 21a1 of the D/A conversion circuit 21. The second standard reference voltage $V_{RL}$ is provided to the output 21b2. In this case, the first capacitor 25 receives the first standard reference voltage $V_{RH}$. The second capacitor 27 receives the second standard reference voltage $V_{RL}$.

Subsequently, the gain stage 15 performs a second storage operation Y1A following the second calculation operation Y1B, as shown in FIG. 5(a). The second storage operation Y1A differs from the second initial storage operation Y1A in that the calculation value $V_O$ in the second calculation operation Y1B is stored in the first capacitor 25, the second capacitor 27, and the third capacitor 29.

The gain stage 15 then repeats the second calculation operation Y1B and the second storage operation Y1A a predetermined number of times as the cyclic type A/D conversion operation. When a digital value obtained after the j_th cyclic operation for the calculation value $V_O(M)$ after the M integral operations is represented by D(j), a relationship between the calculation value $V_O(M)-V_{COM}$ and the digital value D(j) is expressed by Equation (10).

[Math. 10]

$$V_{OFICC}(N) = 2^N \left\{ V_O(M) - \sum_{j=1}^{N} 2^{-j} D(j) \right\} V_c - (2N + 1)V_{RL}$$

$$\cdots (10)$$

<Second embodiment>

The integral gain G that can be set in the A/D converter 11 of the first embodiment has been exemplified as 1.5, 1.0, and 0.5. As will be shown in a modified example below, the A/D converter 11A can also set the integral gain G to 2.0 or 0. In other words, an incremental width of the integral gain G that can be set by the A/D converter 11A of the first embodiment is 0.5. The A/D converter of the second embodiment can set the incremental width of the integral gain G more finely than the A/D converter of the first embodiment.

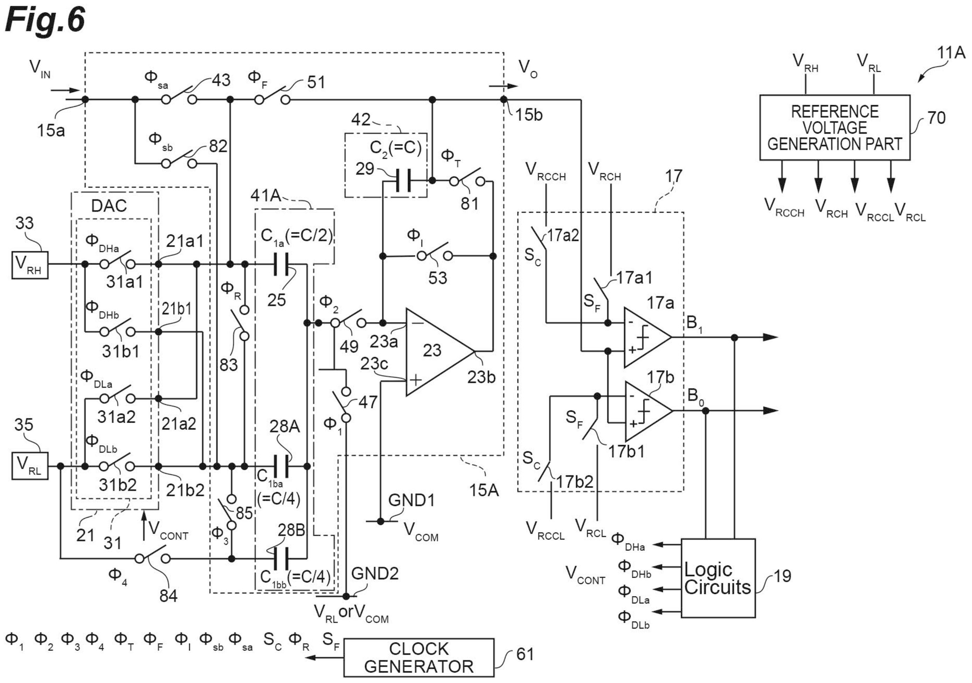

FIG. 6 shows the circuit diagram of the A/D converter 11A of the second embodiment. A difference from the A/D converter 11 of the first embodiment shown in FIG. 1 is that the second capacitor 27 of the A/D converter 11 is divided into two capacitors (a second capacitor 28A and a fourth capacitor 28B). In other words, the A/D converter 11A of the second embodiment includes the first capacitor 25, the second capacitor 28A, the third capacitor 29, and the fourth capacitor 28B. A relationship between the capacitance of each of the capacitors is as follows, with the capacitance of the third capacitor 29 being C.

Capacitance $C_{1a}$ of the first capacitor 25: C/2
Capacitance $C_{1ba}$ of the second capacitor 28A: C/4
Capacitance $C_2$ of the third capacitor 29: C
Capacitance $C_{1bb}$ of the fourth capacitor 28B: C/4 (fourth capacitance)

The fourth capacitor 28B is connected in parallel with the second capacitor 28A. Therefore, the total capacitance of the second capacitor 28A and the fourth capacitor 28B in the second embodiment corresponds to the capacitance $C_{1b}$ of the second capacitor 27 in the first embodiment. In other words, it can be said that the second capacitor 28A and the fourth capacitor 28B in the second embodiment are obtained by dividing the second capacitor 27 in the first embodiment.

For example, an integral gain G(k) can be set as follows. In other words, in the A/D converter 11A, the integral gain G can be set in increments of 0.25.

Integral gain G(1) = 1.75
Integral gains G(2) to G(M-1) = 1.0
Integral gain G(M) = 0.25

The above values of the integral gain G(k) are examples.

Since the total capacitance of the second capacitor 28A and the fourth capacitor 28B needs to be the same as that of the second capacitor 27, a capacitance $C_{1ba}$ of the second capacitor 28A and a capacitance $C_{1bb}$ of the fourth capacitor 28B are not limited to being the same (=C/4) as described above. For example, the capacitance $C_{1ba}$ of the second capacitor 28A may be set to $0.1 \times C$, and the capacitance $C_{1bb}$ of the fourth capacitor 28B may be set to $0.4 \times C$.

In addition, the A/D converter 11A has two additional switches 84 and 85. The switch 84 allows the standard voltage source 35 to be connected to the fourth capacitor 28B. The switch 85 allows an input 15a of the gain stage 15A to be connected to the fourth capacitor 28B.

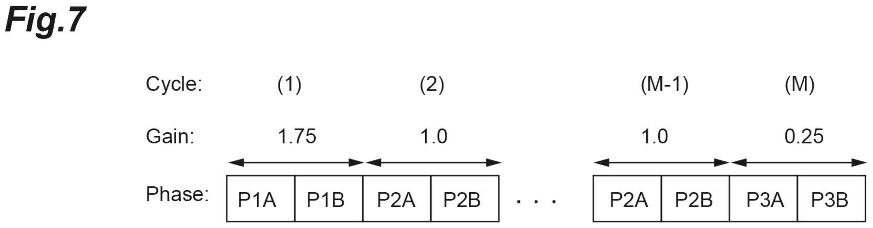

The operation of the A/D converter 11A is described below. As shown in FIG. 7, the A/D converter 11A performs the first storage operation P1A and the first calculation operation P1B. The first storage operation P1A and the first calculation operation P1B correspond to the first integral operation among the integral operations performed M times (refer to FIG. 7). The integral gain G(1) in the first storage operation P1A and the first calculation operation P1B is 1.75.

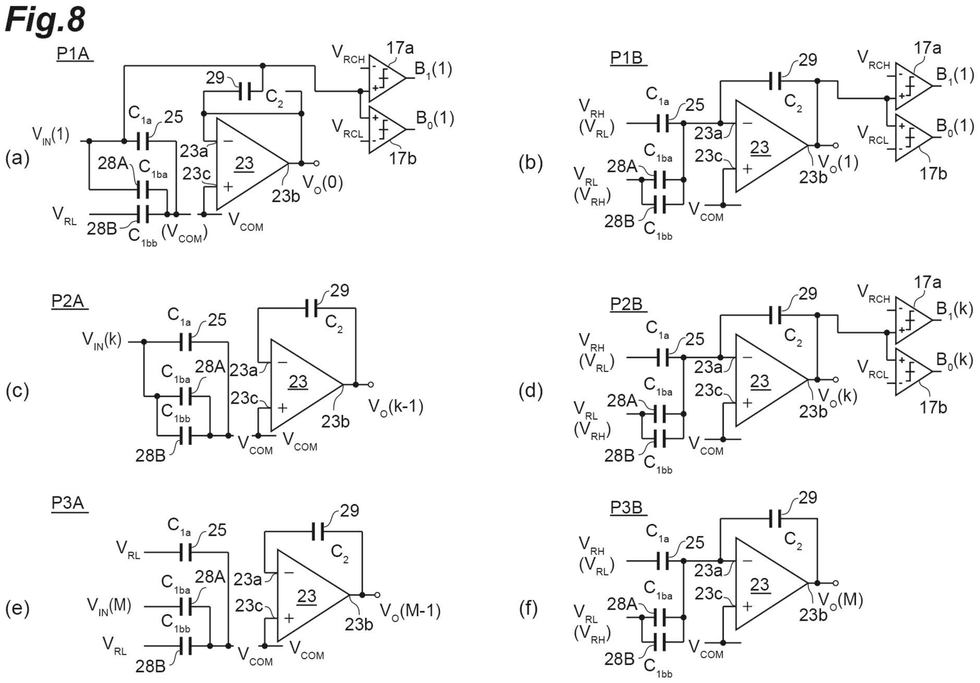

The A/D converter 11A performs the first storage operation P1A. FIG. 8(a) shows a circuit configuration in the first storage operation P1A. This circuit configuration is realized by control signals ($\varphi_{DHa}=0$, $\varphi_{DHb}=0$, $\varphi_{DLa}=0$, $\varphi_{DLb}=0$) and control signals ($\varphi_{sa}=1$, $\varphi_{sb}=1$, $\varphi_1=1$, $\varphi_2=0$, $\varphi_3=0$, $\varphi_4=1$, $\varphi_F=1$, $\varphi_I=1$, $\varphi_T=0$, $\varphi_R=0$, $S_F=1$, $S_C=0$) output from the clock generator 61.

According to the circuit configuration in FIG. 8(a), the first capacitor 25 is connected to the input 15a of the gain stage 15A and the second standard potential GND2. As a result, the first capacitor 25 receives the input value $V_{IN}$. The second capacitor 28A is connected to the input 15a of the gain stage 15A and the second standard potential GND2. As a result, the second capacitor 28A also receives the input value $V_{IN}$. The third capacitor 29 is connected to the input 15a of the gain stage 15A and the operational amplifier circuit 23. Specifically, one end portion of the third capacitor 29 is connected to the first input 23a and the output 23b of the operational amplifier circuit 23. As a result, the third capacitor 29 also receives the input value $V_{IN}$. The fourth capacitor 28B is connected to the standard voltage source 35 and the second standard potential GND2. As a result, the fourth capacitor 28B receives the second standard reference voltage $V_{RL}$. In other words, when the integral gain G is set to 1.75, the input value $V_{IN}$ is stored in the first capacitor 25, the second capacitor 28A, and the third capacitor 29.

Following the first storage operation P1A, the A/D converter 11A performs the first calculation operation P1B. FIG. 8(b) shows a circuit configuration in the first calculation operation P1B. This circuit configuration is realized by control signals ($\varphi_{DHa}$=1, $\varphi_{DHb}$=0, $\varphi_{DLa}$=0, $\varphi_{DLb}$=1) and control signals ($\varphi_{sa}$=0, $\varphi_{sb}$=0, $\varphi_1$=0, $\varphi_2$=1, $\varphi_3$=0, $\varphi_4$=1, $\varphi_F$=0, $\varphi_I$=0, $\varphi_T$=1, $\varphi_R$=0, $S_F$=1, $S_C$=0) output from the clock generator 61.

According to the circuit configuration in FIG. 8(b), the first capacitor 25 is connected to the output 21a1 of the D/A conversion circuit 21 and the first input 23a of the operational amplifier circuit 23. As a result, the first capacitor 25 receives the first standard reference voltage $V_{RH}$. The second capacitor 28A is connected to the output 21b2 of the D/A conversion circuit 21 and the first input 23a of the operational amplifier circuit 23. As a result, the second capacitor 28A receives the second standard reference voltage $V_{RL}$. The third capacitor 29 is connected between the first input 23a of the operational amplifier circuit 23 and the output 23b of the operational amplifier circuit 23. The fourth capacitor 28B is connected to the standard voltage source 35 and the first input 23a of the operational amplifier circuit 23. As a result, the fourth capacitor 28B receives the second standard reference voltage $V_{RL}$.

In addition, the comparator 17a receives the first conversion reference voltage $V_{RCH}$. The comparator 17a compares the calculation value $V_O(1)$ with the first conversion reference voltage $V_{RCH}$ and outputs a calculation value $B_1(1)$ according to the comparison result. In addition, the comparator 17b receives the second conversion reference voltage $V_{RCL}$. The comparator 17b compares the calculation value $V_O(1)$ with the second conversion reference voltage $V_{RCL}$ and outputs a calculation value $B_0(1)$ according to the comparison result.

Specifically, the output (the digital value D) of the A/D conversion circuit 17 is as follows.
[Math. 11]

$$D(1) = \begin{cases} 0 & (V_{IN}(1) < V_{RCL}) \\ 1 & (V_{RCL} \leq V_{IN}(1) < V_{RCH}) \cdots (1\ 1) \\ 2 & (V_{RCH} \leq V_{IN}(1)) \end{cases}$$

According to the connection configuration, the calculation value $V_O(1)$ is generated at the output 23b of the operational amplifier circuit 23.
[Math. 12]

$$V_O(1) = 1.75V_{IN}(1) + 0.5V_{RL} - V_R(1) \cdots (1\ 2)$$

[Math. 13]

$$V_R(1) = \begin{cases} V_{RH} & (D(1) = 2) \\ \dfrac{V_{RH} + V_{RL}}{2} & (D(1) = 1) \cdots (1\ 3) \\ V_{RL} & (D(1) = 0) \end{cases}$$

Next, the A/D converter 11A performs the second storage operation P2A and the second calculation operation P2B. The integral gain G(2) in the second storage operation P2A and the second calculation operation P2B is 1.0.

FIG. 8(c) shows a circuit configuration in the second storage operation P2A in which the integral gain G(2)=1.0. This circuit configuration is realized by control signals ($\varphi_{DHa}$=0, $\varphi_{DHb}$=0, $\varphi_{DLa}$=0, $\varphi_{DLb}$=0) and control signals ($\varphi_{sa}$=1, $\varphi_{sb}$=1, $\varphi_1$=1, $\varphi_2$=0, $\varphi_3$=1, $\varphi_4$=0, $\varphi_F$=0, $\varphi_I$=0, $\varphi_T$=1, $\varphi_R$=0, $S_F$=1, $S_C$=0) output from the clock generator 61.

According to the circuit configuration in FIG. 8(c), the first capacitor 25 is connected to the input 15a of the gain stage 15A and the second standard potential GND2. As a result, the first capacitor 25 receives the input value $V_{IN}$. The second capacitor 28A is connected to the input 15a of the gain stage 15A and the second standard potential GND2. As a result, the second capacitor 28A also receives the input value $V_{IN}$. The third capacitor 29 is connected to the first input 23a of the operational amplifier circuit 23 and the output 23b of the operational amplifier circuit 23. The fourth capacitor 28B is connected to the input 15a of the gain stage 15A and the second standard potential GND2. As a result, the fourth capacitor 28B also receives the input value $V_{IN}$.

In other words, when the integral gain G is set to 1.0, the input value $V_{IN}$ is stored in the first capacitor 25, the second capacitor 28A, and the fourth capacitor 28B.

Following the second storage operation P2A, the A/D converter 11A performs the second calculation operation P2B, as shown in FIG. 8(d). The second calculation operation P2B is performed with the same circuit configuration as that of the first calculation operation P1B described above (refer to FIG. 8(b)). Therefore, a detailed description of the second calculation operation P2B will be omitted.

In the second calculation operation P2B, the output of the A/D conversion circuit 17 is as follows.

[Math. 14]

$$D(k) = \begin{cases} 0 & (V_O(k-1) < V_{RCL}) \\ 1 & (V_{RCL} \le V_O(k-1) < V_{RCH}) \cdots (1\,4) \\ 2 & (V_{RCH} \le V_O(k-1)) \end{cases}$$

With this connection configuration, the calculation value $V_O(k)$ is generated at the output 23b of the operational amplifier circuit 23.

[Math. 15]

$$V_O(k) = V_O(k-1) + V_{IN}(k) - V_R(k) \cdots (1\,5)$$

[Math. 16]

$$V_R(k) = \begin{cases} V_{RH} & (D(k) = 2) \\ \dfrac{V_{RH} + V_{RL}}{2} & (D(k) = 1) \cdots (1\,6) \\ V_{RL} & (D(k) = 0) \end{cases}$$

Next, the A/D converter 11A performs the third storage operation P3A and the third calculation operation P3B. The integral gain G(M) in the third storage operation P3A and the third calculation operation P3B is 0.25. FIG. 8(e) shows a circuit configuration in the third storage operation P3A. This circuit configuration is realized by control signals ($\varphi_{DHa}=0$, $\varphi_{DHb}=0$, $\varphi_{DLa}=1$, $\varphi_{DLb}=0$) and control signals ($\varphi_{sa}=0$, $\varphi_{sb}=1$, $\varphi_1=1$, $\varphi_2=0$, $\varphi_3=0$, $\varphi_4=1$, $\varphi_F=0$, $\varphi_I=0$, $\varphi_T=1$, $\varphi_R=0$, $S_F=1$, $S_C=0$) output from the clock generator 61.

In the circuit configuration of FIG. 8(e), the first capacitor 25 is connected to the output 21a2 of the D/A conversion circuit 21 and the second standard potential GND2. As a result, the first capacitor 25 receives the second standard reference voltage $V_{RL}$. The second capacitor 28A is connected to the input 15a of the gain stage 15A and the second standard potential GND2. As a result, the second capacitor 28A receives the input value $V_{IN}$. The third capacitor 29 is connected to the first input 23a of the operational amplifier circuit 23 and the output 23b of the operational amplifier circuit 23. The fourth capacitor 28B is connected to the standard voltage source 35 and the second standard potential GND2. As a result, the fourth capacitor 28B also receives the second standard reference voltage $V_{RL}$.

In other words, when the integral gain G is set to 0.25, the input value $V_{IN}$ is stored only in the second capacitor 28A.

Following the third storage operation P3A, the A/D converter 11A performs the third calculation operation P3B, as shown in FIG. 8(f). The third calculation operation P3B is performed by the same circuit configuration as in the first calculation operation P1B described above (refer to FIG. 8(b)). Therefore, a detailed description of the third calculation operation P3B will be omitted.

In the third calculation operation P3B, the output of the A/D conversion circuit 17 is as follows.

[Math. 17]

$$D(M) = \begin{cases} 0 & (V_O(M-1) < V_{RCL}) \\ 1 & (V_{RCL} \leq V_O(M-1) < V_{RCH}) \\ 2 & (V_{RCH} \leq V_O(M-1)) \end{cases} \cdots (1\,7)$$

According to the connection configuration, the calculation value $V_O(M)$ is generated at the output 23b of the operational amplifier circuit 23.

[Math. 18]

$$V_O(M) = V_O(M-1) + 0.25V_{IN}(M) + 0.5V_{RL} - V_R(M) \cdots (1\,8)$$

[Math. 19]

$$V_R(M) = \begin{cases} V_{RH} & (D(M) = 2) \\ \dfrac{V_{RH} + V_{RL}}{2} & (D(M) = 1) \\ V_{RL} & (D(M) = 0) \end{cases} \cdots (1\,9)$$

Next, the second A/D conversion operation in the A/D converter 11A shown in FIG. 6 is described. The cyclic type A/D conversion operation in the A/D converter 11A is described below.

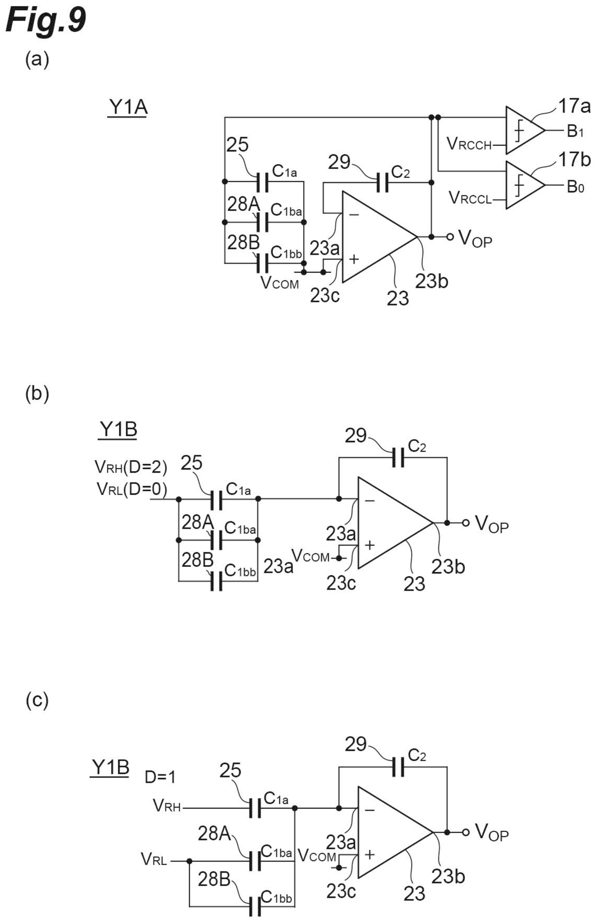

FIGS. 9(a), 9(b), and 9(c) are circuit diagrams for describing the second A/D conversion operation.

First, the gain stage 15A performs the second initial storage operation Y1A, as shown in FIG. 9(a). In the second initial storage operation Y1A, the calculation value $V_O(M)$ in the folding integral type A/D conversion operation P is stored in the first capacitor 25, the second capacitor 28A, the third capacitor 29, and the fourth capacitor 28B. In the second initial storage operation Y1A, the gain stage 15A receives control signals ($\varphi_{sa}$=0, $\varphi_{sb}$=0, $\varphi_1$=1, $\varphi_2$=0, $\varphi_3$=1, $\varphi_4$=0, $\varphi_F$=1, $\varphi_I$=0, $\varphi_T$=1, $\varphi_R$=1, $S_F$=0, $S_C$=1). Further, the D/A conversion circuit 21 receives control signals ($\varphi_{DHa}$=0, $\varphi_{DHb}$=0, $\varphi_{DLa}$=0, $\varphi_{DLb}$=0). Furthermore, in the second initial storage operation Y1A, the calculation value $V_O(M)$ in the folding integral type A/D conversion operation is provided to the comparators 17a and 17b. The comparators 17a and 17b generate a digital value D based on the provided calculation value $V_O(M)$.

Subsequently, following the second initial storage operation Y1A, the gain stage 15A performs the second calculation operation Y1B according to the digital value D (=$B_1$+$B_0$), as shown in FIG. 9(b) or FIG. 9(c). In the second calculation operation Y1B, the gain stage 15A generates the calculation value $V_O$ using the operational amplifier circuit 23, the first capacitor 25, the second capacitor 28A, the third capacitor 29, and the fourth capacitor 28B.

When the output of the A/D conversion circuit 17 is D=2, the switch circuit 31 receives control signals ($\varphi_{DHa}$=1, $\varphi_{DHb}$=1, $\varphi_{DLa}$=0, $\varphi_{DLb}$=0). In addition, when the output of the A/D conversion circuit 17 is D=2, the gain stage 15A receives control signals ($\varphi_{sa}$=0, $\varphi_{sb}$=0, $\varphi_1$=0, $\varphi_2$=1, $\varphi_3$=1, $\varphi_4$=0, $\varphi_F$=0, $\varphi_I$=0, $\varphi_T$=1, $\varphi_R$=0, $S_F$=0, $S_C$=1). As a result, the circuit shown in FIG. 9(b) operates. In other words, each of the first capacitor 25, the second capacitor 28A and the fourth capacitor 28B receives the first standard reference voltage $V_{RH}$.

When the output of the A/D conversion circuit 17 is D=0, the switch circuit 31 receives control signals ($\varphi_{DHa}$=0, $\varphi_{DHb}$=0, $\varphi_{DLa}$=1, $\varphi_{DLb}$=1). Additionally, when the output of the A/D conversion circuit 17 is D=0, the gain stage 15A receives control signals ($\varphi_{sa}$=0, $\varphi_{sb}$=0, $\varphi_1$=0, $\varphi_2$=1, $\varphi_3$=0, $\varphi_4$=1, $\varphi_F$=0, $\varphi_I$=0, $\varphi_T$=1, $\varphi_R$=0, $S_F$=0, $S_C$=1). As a result, the circuit shown in FIG. 9(b) operates. In other words, each of the first capacitor 25, the second capacitor 28A and the fourth capacitor 28B receives the second standard reference voltage $V_{RL}$.

When the output of the A/D conversion circuit 17 is D=1, the switch circuit 31 receives control signals ($\varphi_{DHa}$=1, $\varphi_{DHb}$=0, $\varphi_{DLa}$=0, $\varphi_{DLb}$=1). Additionally, when the output of the A/D conversion circuit 17 is D=1, the gain stage 15A receives the control signals ($\varphi_{sa}$=0, $\varphi_{sb}$=0, $\varphi_1$=0, $\varphi_2$=1, $\varphi_3$=0, $\varphi_4$=1, $\varphi_F$=0, $\varphi_I$=0, $\varphi_T$=1, $\varphi_R$=0, $S_F$=0, $S_C$=1). As a result, the circuit shown in FIG. 9(c) operates. In other words, the first capacitor 25 receives the first standard reference voltage $V_{RH}$. Each of the second capacitor 28A and the fourth capacitor 28B receives the second standard reference voltage $V_{RL}$.

Then, the gain stage 15A repeats the second storage operation Y1A and the second calculation operation Y1B a predetermined number of times as the cyclic type A/D conversion operation. As a result, an output value that is a digital value is obtained from an input value that is an analog value.

Similarly to the A/D converter 11 of the first embodiment, the A/D converter 11A of the second embodiment can also obtain a good effectiveness of noise reduction while keeping the calculation results of the integral operation within the desired range. Furthermore, the A/D converter 11A of the second embodiment divides the second capacitor 27 in the first embodiment into the second capacitor 28A and the fourth capacitor 28B, that is, the integral gain G can be set more finely than in the A/D converter 11 of the first embodiment by increasing the number of capacitors that store analog signals.

The A/D converter and the A/D conversion method according to the present disclosure have been described above. The A/D converter and the A/D conversion method according to the present disclosure are not limited to the above embodiments.

<Modified example 1>

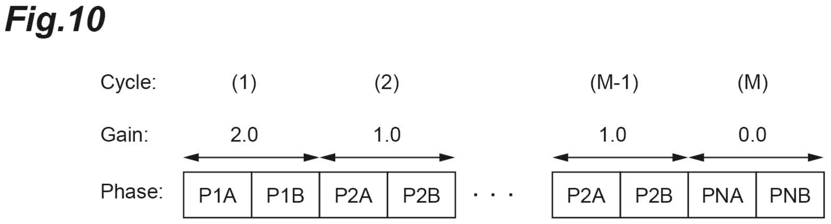

In the folding integral type A/D conversion operation performed M times, the setting of the integral gain G is not limited to the manner described in the first embodiment. In Modified example 1, as shown in FIG. 10, the integral gain G(k) may be set as follows.

Integral gain G(1)=2.0
Integral gains G(2) to G(M-1)=1.0
Integral gain G(M)=0

In other words, in Modified example 1, 2 is set as the integral gain G(1) in the first integral operation. Then, 0 is set as the integral gain G(M) in the M_th integral operation. The integral gains G(2) to G(M-1) in the second to (M-1)_th integral operations are the same (=1) as in the first embodiment.

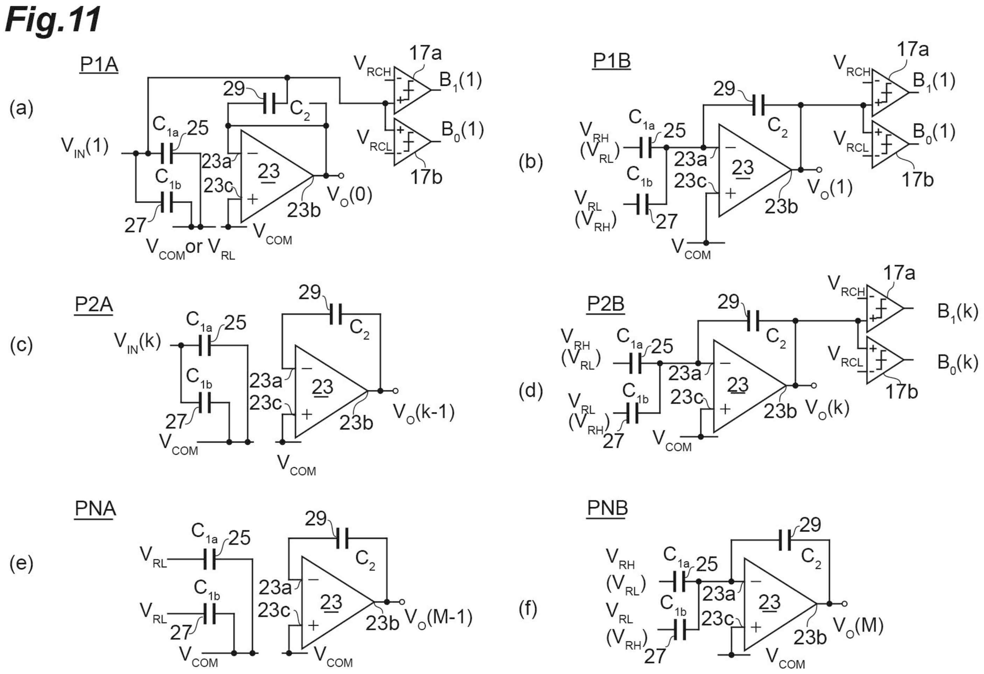

FIG. 11(a) shows a circuit configuration in the first storage operation P1A in which the integral gain G(1)=2.0. FIG. 11(e) shows a circuit configuration in the third storage operation PNA in which the integral gain G(M)=0. The circuit configurations shown in FIGS. 11(b), 11(c), 11(d), and 11(f) are the same as those shown in FIGS. 3(b), 3(c), 3(d), and 3(f), respectively, described in the first embodiment.

The circuit configuration shown in FIG. 11(a) is realized by control signals ($\varphi_{DHa}$=0, $\varphi_{DHb}$=0, $\varphi_{DLa}$=0, $\varphi_{DLb}$=0) and control signals ($\varphi_{sa}$=1, $\varphi_{sb}$=1, $\varphi_1$=1, $\varphi_2$=0, $\varphi_F$=1, $\varphi_I$=1, $\varphi_T$=0, $\varphi_R$=0, $S_F$=1, $S_C$=0) output from the clock generator 61.

According to the circuit configuration in FIG. 11(a), the first capacitor 25 is connected to the input 15a of the gain stage 15 and the second standard potential GND2. As a result, the first capacitor 25 receives the input value $V_{IN}$. The second capacitor 27 is connected to the input 15a of the gain stage 15 and the second standard potential GND2. As a result, the second capacitor 27 also receives the input value $V_{IN}$. The third capacitor 29 is connected to the input 15a of the gain stage 15 and the operational amplifier circuit 23. As a result, the third capacitor 29 also receives the input value $V_{IN}$. In other words, when the integral gain G is set to 2.0, the input value $V_{IN}$ is stored in the first capacitor 25, the second capacitor 27 and the third capacitor 29.

The circuit configuration shown in FIG. 11(e) is realized by control signals ($\varphi_{DHa}$=0, $\varphi_{DHb}$=0, $\varphi_{DLa}$=1, $\varphi_{DLb}$=1) and control signals ($\varphi_{sa}$=0, $\varphi_{sb}$=0, $\varphi_1$=1, $\varphi_2$=0, $\varphi_F$=0, $\varphi_I$=0, $\varphi_T$=1, $\varphi_R$=0, $S_F$=1, $S_C$=0) output from the clock generator 61.

According to the circuit configuration in FIG. 11(e), the first capacitor 25 is connected to the output 21a2 of the D/A conversion circuit 21 and the second standard potential GND2. As a result, the first capacitor 25 receives the second standard reference voltage $V_{RL}$. The second capacitor 27 is connected to the output 21b2 of the D/A conversion circuit 21 and the second standard potential GND2. As a result, the second capacitor 27 also receives the second standard reference voltage $V_{RL}$. The third capacitor 29 is connected to the first input 23a of the operational amplifier circuit 23 and the output 23b of the operational amplifier circuit 23. In other words, when the integral gain G is set to 0, the input value $V_{IN}$ is not stored in any of the capacitors.

<Modified example 2>

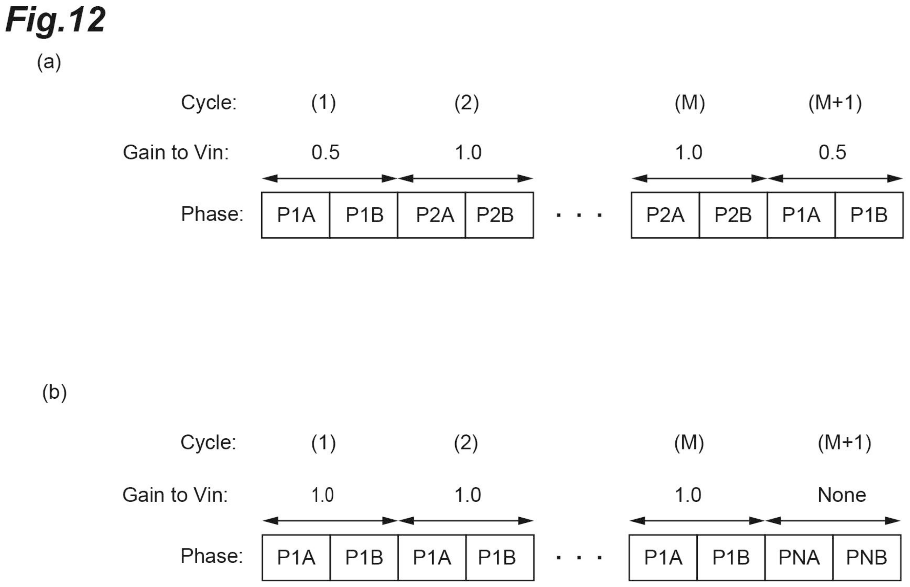

Furthermore, in Modified example 2, as shown in FIG. 12(a), the integral gain G(k) may be set as follows.

Integral gain G(1)=0.5
Integral gains G(2) to G(M)=1.0
Integral gain G(M+1)=0.5

In other words, in Modified example 2, the integral gain G(1) in the first integral operation is set to 0.5. The integral gains G(2) to G(M) in the second to M_th integral operations are 1.0, and the integral gain G(M+1) in the (M+1)_th integral operation is 0.5.

<Modified example 3>

Furthermore, in Modified example 3, as shown in FIG. 12(b), the integral gain G(k) may be set as follows.

Integral gains G(1) to G(M)=1.0
Integral gain G(M+1) = 0

In other words, in Modified example 3, 1 is set as the integral gains G(1) to G(M) in the first to M integral operations. Then, 0 is set as the integral gain G(M+1) in the (M+1)_th integral operation.

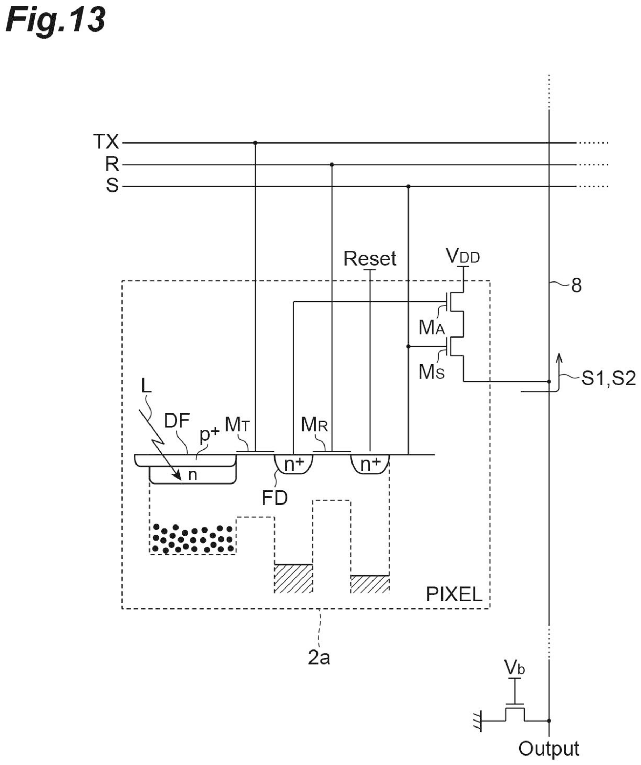

Some of the exemplary A/D converters described above can be applied to image sensor devices. FIG. 13 is a diagram showing a pixel of an image sensor. The image sensor device includes a cell array and a converter array. The cell array includes a plurality of image sensor cells 2a disposed in a two-dimensional configuration. The converter array is connected to the cell array and includes a plurality of A/D converters 11. The A/D converter 11 is connected to the image sensor cell 2a via a column line 8 of the cell array.

The image sensor cell 2a is, for example, a CMOS image sensor cell. A photodiode DF receives light L for one pixel associated with an image. A gate of a selection transistor $M_S$ is connected to a row selection line S that extends in a row direction. A gate of a reset transistor $M_R$ is connected to a reset line R. A gate of a transfer transistor $M_T$ is connected to a transfer selection line TX that extends in the row direction. One end of the photodiode DF is connected to a floating diffusion layer FD via the transfer transistor $M_T$. The floating diffusion layer FD is connected to a reset potential line Reset via the reset transistor $M_R$ and to a gate of a transistor $M_A$. One current terminal (for example, a drain) of the transistor $M_A$ is connected to the column line 8 via the selection transistor $M_S$. The transistor $M_A$ provides a potential to the column line via the selection transistor $M_S$ according to an amount of charge in the floating diffusion layer FD.

The image sensor cell 2a having this structure generates a first signal indicating a reset level and a second signal indicating a signal level superimposed on the reset level. In other words, in the image sensor cell 2a, first, a control signal provided to the reset line R is provided to the reset transistor $M_R$, and the floating diffusion layer FD is reset. This reset level is read out via the transistor $M_A$. Next, a charge transfer control signal is provided to the transfer transistor $M_T$, and a photo-induced signal charge is transferred from the photodiode DF to the floating diffusion layer FD. This signal level is then read out via the transistor $M_A$. In this way, the image sensor cell 2a can generate a first signal S1 indicating the reset level and a second signal S2 indicating the signal level superimposed on the reset level.

<Analysis example 1>

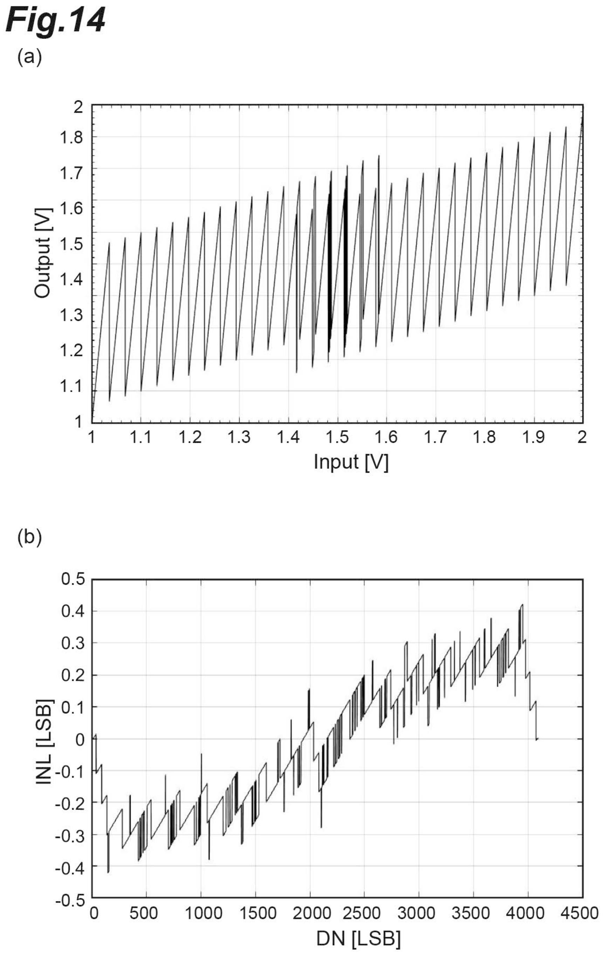

FIG. 14(a) shows a relationship between the input and the output of the gain stage 15. FIG. 14(a) is a result of a simulation. A horizontal axis shows the input value $V_{IN}$. A vertical axis shows the calculation value $V_O$. In this simulation, the number of integrals was set to 16 (M=16, 5 bits). Then, in the 16 integral operations, the first integral gain G(1) was set to 1.5, the second to fifteenth integral gains G(2) to G(15) were set to 1.0, and the sixteenth integral gain G(16) was set to 0.5. In addition, for the simulation, the following values were employed.

First standard reference voltage/$V_{RH}$: 2.0V
Second standard reference voltage/$V_{RL}$: 1.0V
First conversion reference voltage/folding integral type/$V_{RCH}$: 1.95V
Second conversion reference voltage/folding integral type/$V_{RCL}$: 1.55V
The values for the cyclic type operation are as follows.
First conversion reference voltage/cyclic type/$V_{RCCH}$: 1.625V
Second conversion reference voltage/cyclic type/$V_{RCCL}$: 1.375V

As shown in FIG. 14(a), a range of the output, that is, the calculation value $V_O$, can be kept within a range from +1V to +2V. Furthermore, according to the setting of the integral gain G described above, an average integral gain in the 16 integral operations is 1. In other words, it was found that the calculation value $V_O$ can be kept within the desired range (from +1 V to +2 V) even when the average integral gain is set to 1. In this case, the integral gain is doubled compared to when the integral gain from the first to sixteenth times is set to 0.5. As a result, it was also confirmed that the S/N ratio for random noise was improved by factor of $\sqrt{2}$ times. Furthermore, by setting the integral gains G(2) to G(15) to 1.0, matching with the foldback voltage (0.5V) is achieved. As a result, it was also confirmed that a resolution of $\log_2(2M)$ bits could be obtained.

Further, FIG. 14(b) is a graph showing an evaluation of integral nonlinearity of the total A/D conversion operation resulting from the above settings and seven cyclic type A/D conversion operations (8 bits). According to FIG. 14(b), it was confirmed that the nonlinearity was kept within a range of $\pm 0.5$ bits. According to this range, it was also confirmed that there is no significant effect on the number of bits required.

<Analysis example 2>

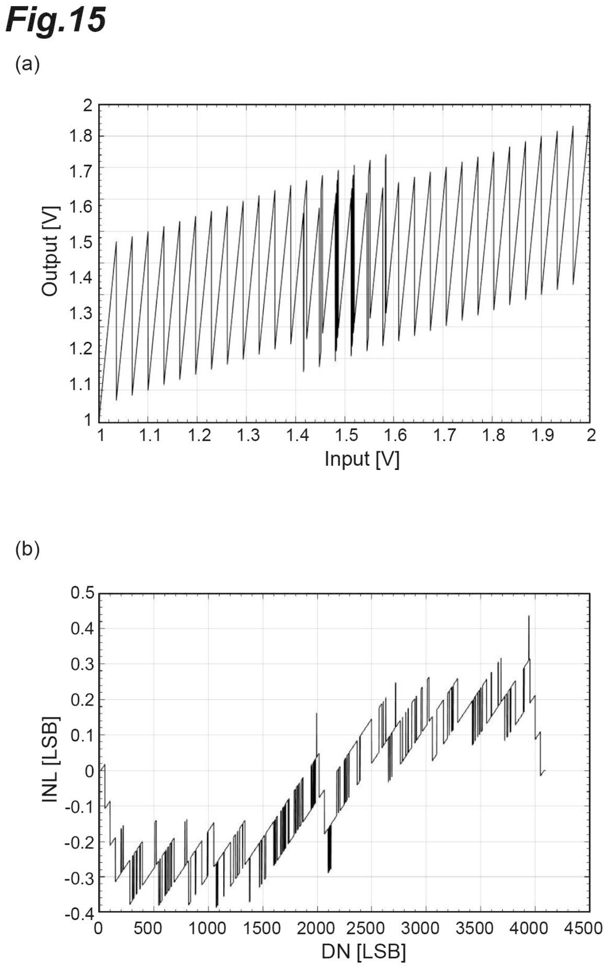

FIG. 15(a) is a result of another simulation showing the relationship between the input and the output of the gain stage 15. In this simulation, the number of integrals was set to 17 (M=17, 5 bits). Then, in the 17 integral operations, the first integral gain G(1) was set to 0.5, the second to sixteenth integral gains G(2) to G(16) were set to 1.0, and the seventeenth integral gain G(17) was set to 0.5. Furthermore, for the simulation, the following values which are the same as in Analysis example 1 were employed.

First standard reference voltage/$V_{RH}$: 2.0V
Second standard reference voltage/$V_{RL}$: 1.0V
First conversion reference voltage/folding integral type/$V_{RCH}$: 1.95V
Second conversion reference voltage/folding integral type/$V_{RCL}$: 1.55V
The values for cyclic operation are as follows.
First conversion reference voltage/cyclic type/$V_{RCCH}$: 1.625V
Second conversion reference voltage/cyclic type/$V_{RCCL}$: 1.375V

As shown in FIG. 15(a), it was confirmed that the range of the output, that is, the calculation value $V_O$, was kept within the range from +1V to +2V even with the setting of the integral gain G described above. FIG. 15(b) is a graph showing an evaluation of the integral nonlinearity of the total A/D conversion operation resulting from the above settings and seven cyclic type A/D conversion operations (8 bits). According to FIG. 15(b), it was confirmed that the nonlinearity was kept within the range of ±0.5 bits, similar to Analysis example 1. According to this range, it was also confirmed that there is no significant effect on the number of bits required.

<Analysis example 3>

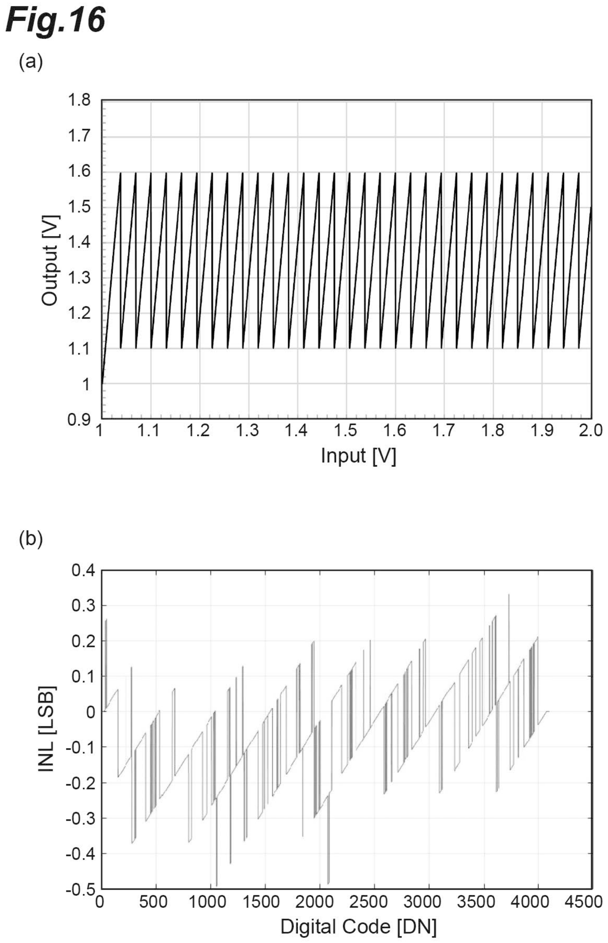

FIG. 16(a) shows a result of a simulation of the relationship between input and output, which also takes into account the cyclic operation, in addition to the folding integral type A/D conversion operation. In this simulation, the number of integrals was set to 16 (M=16, 5 bits). Then, in the 16 integral operations, the first integral gain G(1) was set to 2.0, the second to fifteenth integral gains G(2) to G(15) were set to 1.0, and the sixteenth integral gain G(16) was set to 0. In addition, for the simulation, the following values were employed.

First standard reference voltage/$V_{RH}$: 2.0V
Second standard reference voltage/$V_{RL}$: 1.0V
First conversion reference voltage/folding integral type/$V_{RCH}$:2.1 V
Second conversion reference voltage/folding integral type/$V_{RCL}$: 1.6V
The values for cyclic operation are as follows.
First conversion reference voltage/cyclic type/$V_{RCCH}$: 1.625V
Second conversion reference voltage/cyclic type/$V_{RCCL}$: 1.375V

As shown in FIG. 16(a), it was confirmed that the range of the output could be kept within a range from +1.0 V to +1.6 V (0.6V). FIG. 16(b) is a graph evaluating the integral nonlinearity of the total A/D conversion operation in the folding integral type A/D conversion operation with the number of integrals set to 8 times (M=8, 4 bits) and the eight cyclic type A/D conversion operations (9 bits) at the above voltage settings. According to FIG. 16(b), when the amplifier gain was 85 dB, a mismatch error, which indicates nonlinearity, was found to be 0.1%.

[Addendum]

The above-described A/D converter and A/D conversion method are as described in [1] to [11] below. These have been described in detail based on each of the embodiments and modified examples described above.

[1] A first example is an A/D converter that performs an A/D conversion including a folding integral to obtain a digital value from an analog signal by repeatedly performing operations including sampling of an input signal and an integral of a sampled value, and includes a gain stage that outputs a calculation value based on the analog signal and an A/D conversion circuit that outputs a result that can be used to generate the digital value by comparing the calculation value output by the gain stage with a conversion reference voltage, wherein the gain stage generates the calculation value based on the analog signal using a first integral gain in a k_th operation (k is an integer equal to or less than M-1) among the operations that are performed M times (M is an integer equal to or greater than 2), and generates the calculation value based on the analog signal using a second integral gain in a (k+1)_th operation, and the second integral gain is smaller than the first integral gain.
[2] A second example is an A/D converter according to the first example, wherein the gain stage generates the calculation value based on the analog signal using a third integral gain in the first operation, and the third integral gain is greater than the first integral gain.

[3] A third example is an A/D converter according to the first or second example, wherein a third A/D converter uses the first integral gain in second to (M-1)_th operations of the first or second A/D converter, and uses the second integral gain in an M_th operation.

[4] A fourth example is an A/D converter selected from the first, second and third examples, wherein the first integral gain is 1 or more and the second integral gain is 0 or more and less than 1.

[5] A fifth example is an A/D converter that performs an A/D conversion including a folding integral to obtain a digital value from an analog signal by repeatedly performing operations including sampling of an input signal and an integral of a sampled value, and includes a gain stage that outputs a calculation value based on the analog signal and an A/D conversion circuit that outputs a result that can be used to generate the digital value by comparing the calculation value output by the gain stage with a conversion reference voltage, wherein the gain stage includes a stage input that receives the analog signal, an operational amplifier circuit that generates the calculation value based on the analog signal, a stage output that outputs the calculation value to the A/D conversion circuit, a front stage capacitance part that is connectable to the stage input and an input of the operational amplifier circuit and includes at least one front stage capacitor, and a feedback capacitance part that is connectable to the stage input and an output of the operational amplifier circuit and includes one feedback capacitor, the gain stage selectively configures a first circuit and a second circuit different from the first circuit in the sampling of the input signal, the first circuit stores the analog signal in the at least one front stage capacitor by connecting the front stage capacitance part to the stage input, and stores the analog signal in the feedback capacitor by connecting the feedback capacitance part to the stage input, so that a ratio between a capacitance of the front stage capacitance part and a capacitance of the feedback capacitance part is set to a predetermined capacitance ratio, and the second circuit stores the analog signal in the at least one front stage capacitor by connecting the front stage capacitance part to the stage input, and does not store the analog signal in the feedback capacitor by disconnecting the feedback capacitance part from the stage input, so that a ratio between the capacitance of the front stage capacitance part and the capacitance of the feedback capacitance part is a capacitance ratio that is smaller than the capacitance ratio in the first circuit.

[6] A sixth example is an A/D converter according to the fifth example, wherein the ratio between the capacitance of the front stage capacitance part and the capacitance of the feedback capacitance part depends on a magnitude of the integral gain.

[7] A seventh example is an A/D converter according to the fifth or sixth example, wherein the operations are performed M times (M is an integer equal to or greater than 2), and in the sampling of the input signal in a first operation, the first circuit is used so that the ratio between the capacitance of the front stage capacitance part and the capacitance of the feedback capacitance part is set to the predetermined capacitance ratio.

[8] An eighth example is an A/D converter selected from the fifth, sixth and seventh examples, wherein the operations are performed M times (M is an integer equal to or greater than 2), and in the sampling of the input signal in second to (M-1)_th operations, the second circuit is used so that the ratio between the capacitance of the front stage capacitance part and the capacitance of the feedback capacitance part is set to a capacitance ratio that is smaller than the predetermined capacitance ratio in the first circuit.

[9] A ninth example is an A/D converter selected from the fifth, sixth, seventh and eighth examples, wherein the operations are performed M times (M is an integer equal to or greater than 2), and in the sampling of the input signal in second to (M-1)_th operations, the number of the front stage capacitors that store the analog signal in the second circuit is set to 2 or more, so that the ratio between the capacitance of the front stage capacitance part and the capacitance of the feedback capacitance part is set to a first capacitance ratio that is smaller than the predetermined capacitance ratio in the first circuit, and in the sampling of the input signal in an M_th operation, the number of the front stage capacitors that store the analog signal in the second circuit is set to 0 or 1, so that the ratio between the capacitance of the front stage capacitance part and the capacitance of the feedback capacitance part is set to a second capacitance ratio that is smaller than the first capacitance ratio.

[10] A tenth example is an A/D converter selected from the fifth, sixth, seventh, eighth and ninth examples, wherein a capacitance of the feedback capacitor is greater than a capacitance of the front stage capacitor.

[11] An eleventh example is an A/D converter selected from the fifth, sixth, seventh, eighth and ninth examples, wherein a capacitance of the feedback capacitor is greater than a capacitance of the first front stage capacitor, and the capacitance of the first front stage capacitor is different from a capacitance of a second front stage capacitor different from the first front stage capacitor.

[12] A twelfth example is an A/D conversion method that performs an A/D conversion including a folding integral to obtain a digital value from an analog signal by repeatedly performing operations including sampling of an input signal and an integral of a sampled value, the method including generating a first calculation value based on the analog signal by performing the operations using a first integral gain; and generating a second calculation value based on the analog signal by performing the operations using a second integral gain after the generating of the first calculation value, wherein the second integral gain is smaller than the first integral gain.

[13] A thirteenth example is an A/D conversion method according to the twelfth example, further including generating a third calculation value based on the analog signal by performing the operations using a third integral gain before the generating of the first calculation value, wherein the third integral gain is greater than the first integral gain.

[14] A fourteenth example is an A/D conversion method according to the twelfth or thirteenth example, wherein the operations are performed M times (M is an integer equal to or greater than 2), in second to (M-1)_th operations, the generating of the first calculation value is performed, and in an M_th operation, the generating of the second calculation value is performed.

[15] A fifteenth example is an A/D conversion method selected from the twelfth, thirteenth and fourteenth examples, wherein the first integral gain is 1 or more and the second integral gain is 0 or more and less than 1.

[16] A sixteenth example is an A/D conversion method that performs an A/D conversion including a folding integral to obtain a digital value from an analog signal by repeatedly performing operations including sampling of an input signal and an integral of a sampled value, the method including a sampling step of the input signal for storing the analog signal at least in a front stage capacitance part that is connectable to a stage input of a gain stage that outputs a calculation value based on the analog signal among the front stage capacitance part including at least one front stage capacitor and a feedback capacitance part including one feedback capacitor; and an integral step of a sampled value for generating the calculation value at an output of the operational amplifier circuit by connecting at least the front stage capacitance part to an input of the operational amplifier circuit included in the gain stage, wherein in the sampling step of the input signal, either a first storage or a second storage different from the first storage is performed, the first storage stores the analog signal in the at least one front stage capacitor by connecting the front stage capacitance part to the stage input and stores the analog signal in the feedback capacitor by connecting the feedback capacitance part to the stage input, so that a ratio between a capacitance of the front stage capacitance part and a capacitance of the feedback capacitance part is set to a predetermined capacitance ratio, and the second storage stores the analog signal in the at least one front stage capacitor by connecting the front stage capacitance part to the stage input and does not store the analog signal in the feedback capacitor by disconnecting the feedback capacitance part from the stage input, so that the ratio between the capacitance of the front stage capacitance part and the capacitance of the feedback capacitance part is set to a capacitance ratio that is smaller than the predetermined capacitance ratio in the first storage.

[17] A seventeenth example is an A/D conversion method according to the sixteenth example, wherein the ratio between the capacitance of the front stage capacitance part and the capacitance of the feedback capacitance part depends on a magnitude of the integral gain.

[18] An eighteenth example is an A/D conversion method according to the sixteenth or seventeenth example, wherein the operations are performed M times (M is an integer equal to or greater than 2), and in the sampling step of the input signal in a first operation, the first storage is performed so that the ratio between the capacitance of the front stage capacitance part and the capacitance of the feedback capacitance part is set to the predetermined capacitance ratio.

[19] A nineteenth example is an A/D conversion method selected from the sixteenth, seventeenth and eighteenth examples, wherein the operations are performed M times (M is an integer equal to or greater than 2), and in the sampling step of the input signal in second to (M-1)_th operations, the second storage is performed so that the ratio between the capacitance of the front stage capacitance part and the capacitance of the feedback capacitance part is set to a capacitance ratio that is smaller than the predetermined capacitance ratio in the first storage.

[20] A twentieth example is an A/D conversion method selected from the sixteenth, seventeenth, eighteenth and nineteenth examples, wherein the operations are performed M times (M is an integer equal to or greater than 2), in the sampling of the input signal in the second to (M-1)_th operations, the number of the front stage capacitors that store the analog signal in the second storage is set to 2 or more, so that the ratio between the capacitance of the front stage capacitance part and the capacitance of the feedback capacitance part is set to a first capacitance ratio that is smaller than the predetermined capacitance ratio in the first storage, and in the sampling of the input signal in an M_th operation, the number of the front stage capacitors that store the analog signal in the second storage is set to 0 or 1, so that the ratio between the capacitance of the front stage capacitance part and the capacitance of the feedback capacitance part is set to a second capacitance ratio that is smaller than the first capacitance ratio.

**Reference Signs List**

2a...Image sensor cell, 11...A/D converter, 15...Gain stage, 15a...Input, 15b...Output, 17...A/D conversion circuit, 17a, 17b...Comparator, 19...Logic circuit, 21...D/A conversion circuit, 23...Operational amplifier circuit, 23a...First input, 23b...Second input, 25... First capacitor, 27...Second capacitor, 29...Third capacitor, 31...Switch circuit, 43, 49, 51, 53...Switch, 33, 35...Standard voltage source, 61...Clock generator, 70...Reference voltage generation part, $B_1$, $B_0$...Calculation value, $C_{1a}$, $C_{1b}$, $C_2$...Capacitance, D...Digital value, $V_{COM}$... Standard potential, $V_{CONT}$...Control signal, $V_{IN}$...Input value, $V_O$...Calculation value, $V_{RCH}$...First conversion reference voltage, $V_{RCL}$...Second conversion reference voltage, $V_{RH}$...First standard reference voltage, $V_{RL}$...Second standard reference voltage.

**EP 4 742 541 A1**

**Claims**

1. An A/D converter that performs an A/D conversion including a folding integral to obtain a digital value from an analog signal by repeatedly performing operations including sampling of an input signal and an integral of a sampled value, comprising:

   a gain stage configured to output a calculation value based on the analog signal; and
   an A/D conversion circuit configured to output a result that is usable to generate the digital value by comparing the calculation value output by the gain stage with a conversion reference voltage,
   wherein the gain stage generates the calculation value based on the analog signal using a first integral gain in a k_th operation (k is an integer equal to or less than M-1) among the operations that are performed M times (M is an integer equal to or greater than 2), and
   generates the calculation value based on the analog signal using a second integral gain in a (k+1)_th operation, and
   the second integral gain is smaller than the first integral gain.

2. The A/D converter according to claim 1, wherein the gain stage generates the calculation value based on the analog signal using a third integral gain in a first operation, and
   the third integral gain is greater than the first integral gain.

3. The A/D converter according to claim 1, wherein the first integral gain is used in second to (M-1)_th operations, and
   the second integral gain is used in an M_th operation.

4. The A/D converter according to claim 1, wherein the first integral gain is 1 or more and
   the second integral gain is 0 or more and less than 1.

5. An A/D converter that performs an A/D conversion including a folding integral to obtain a digital value from an analog signal by repeatedly performing operations including sampling of an input signal and an integral of a sampled value, comprising:

   a gain stage configured to output a calculation value based on the analog signal; and
   an A/D conversion circuit configured to output a result that is usable to generate the digital value by comparing the calculation value output by the gain stage with a conversion reference voltage,
   wherein the gain stage includes:

   a stage input configured to receive the analog signal;
   an operational amplifier circuit configured to generate the calculation value based on the analog signal;
   a stage output configured to output the calculation value to the A/D conversion circuit;
   a front stage capacitance part configured to be connectable to the stage input and an input of the operational amplifier circuit and including at least one front stage capacitor; and
   a feedback capacitance part configured to be connectable to the stage input and an output of the operational amplifier circuit and including one feedback capacitor,
   the gain stage selectively configures a first circuit and a second circuit different from the first circuit in the sampling of the input signal,
   the first circuit stores the analog signal in the at least one front stage capacitor by connecting the front stage capacitance part to the stage input, and stores the analog signal in the feedback capacitor by connecting the feedback capacitance part to the stage input, so that a ratio between a capacitance of the front stage capacitance part and a capacitance of the feedback capacitance part is set to a predetermined capacitance ratio, and
   the second circuit stores the analog signal in the at least one front stage capacitor by connecting the front stage capacitance part to the stage input, and does not store the analog signal in the feedback capacitor by disconnecting the feedback capacitance part from the stage input, so that a ratio between the capacitance of the front stage capacitance part and the capacitance of the feedback capacitance part is a capacitance ratio that is smaller than the capacitance ratio in the first circuit.

6. The A/D converter according to claim 5, wherein the ratio between the capacitance of the front stage capacitance part and the capacitance of the feedback capacitance part depends on a magnitude of the integral gain.

22

7. The A/D converter according to claim 5, wherein the operations are performed M times (M is an integer equal to or greater than 2), and
in the sampling of the input signal in a first operation, the first circuit is used so that the ratio between the capacitance of the front stage capacitance part and the capacitance of the feedback capacitance part is set to the predetermined capacitance ratio.

8. The A/D converter according to claim 5, wherein the operations are performed M times (M is an integer equal to or greater than 2), and
in the sampling of the input signal in second to (M-1)_th operations, the second circuit is used so that the ratio between the capacitance of the front stage capacitance part and the capacitance of the feedback capacitance part is set to a capacitance ratio that is smaller than the predetermined capacitance ratio in the first circuit.

9. The A/D converter according to claim 5, wherein the operations are performed M times (M is an integer equal to or greater than 2), and

in the sampling of the input signal in second to (M-1)_th operations, the number of the front stage capacitors that store the analog signal in the second circuit is set to 2 or more, so that the ratio between the capacitance of the front stage capacitance part and the capacitance of the feedback capacitance part is set to a first capacitance ratio that is smaller than the predetermined capacitance ratio in the first circuit, and
in the sampling of the input signal in an M_th operation, the number of the front stage capacitors that store the analog signal in the second circuit is set to 0 or 1, so that the ratio between the capacitance of the front stage capacitance part and the capacitance of the feedback capacitance part is set to a second capacitance ratio that is smaller than the first capacitance ratio.

10. The A/D converter according to claim 5, wherein a capacitance of the feedback capacitor is greater than a capacitance of the front stage capacitor.

11. The A/D converter according to claim 5, wherein a capacitance of the feedback capacitor is greater than a capacitance of the first front stage capacitor, and
the capacitance of the first front stage capacitor is different from the capacitance of a second front stage capacitor different from the first front stage capacitor.

12. An A/D conversion method that performs an A/D conversion including a folding integral to obtain a digital value from an analog signal by repeatedly performing operations including sampling of an input signal and an integral of a sampled value, the method comprising:

generating a first calculation value based on the analog signal by performing the operations using a first integral gain; and
generating a second calculation value based on the analog signal by performing the operations using a second integral gain after the generating of the first calculation value,
wherein the second integral gain is smaller than the first integral gain.

13. The A/D conversion method according to claim 12, further comprising generating a third calculation value based on the analog signal by performing the operations using a third integral gain before the generating of the first calculation value,
wherein the third integral gain is greater than the first integral gain.

14. The A/D conversion method according to claim 12, wherein the operations are performed M times (M is an integer equal to or greater than 2),

in second to (M-1)_th operations, the generating of the first calculation value is performed, and
in an M_th operation, the generating of the second calculation value is performed.

15. The A/D conversion method according to claim 12, wherein the first integral gain is 1 or more and the second integral gain is 0 or more and less than 1.

16. An A/D conversion method that performs an A/D conversion including a folding integral to obtain a digital value from an analog signal by repeatedly performing operations including sampling of an input signal and an integral of a sampled value, the method comprising:

a sampling step of the input signal for storing the analog signal at least in a front stage capacitance part that is connectable to a stage input of a gain stage that outputs a calculation value based on the analog signal among the front stage capacitance part including at least one front stage capacitor and a feedback capacitance part including one feedback capacitor; and

an integral step of a sampled value for generating the calculation value at an output of the operational amplifier circuit by connecting at least the front stage capacitance part to an input of the operational amplifier circuit included in the gain stage,

wherein in the sampling step of the input signal, either a first storage or a second storage different from the first storage is performed,

the first storage stores the analog signal in the at least one front stage capacitor by connecting the front stage capacitance part to the stage input and stores the analog signal in the feedback capacitor by connecting the feedback capacitance part to the stage input, so that a ratio between a capacitance of the front stage capacitance part and a capacitance of the feedback capacitance part is set to a predetermined capacitance ratio, and

the second storage stores the analog signal in the at least one front stage capacitor by connecting the front stage capacitance part to the stage input and does not store the analog signal in the feedback capacitor by disconnecting the feedback capacitance part from the stage input, so that the ratio between the capacitance of the front stage capacitance part and the capacitance of the feedback capacitance part is set to a capacitance ratio that is smaller than the predetermined capacitance ratio in the first storage.

17. The A/D conversion method according to claim 16, wherein the ratio between the capacitance of the front stage capacitance part and the capacitance of the feedback capacitance part depends on a magnitude of the integral gain.

18. The A/D conversion method according to claim 16, wherein the operations are performed M times (M is an integer equal to or greater than 2), and
in the sampling step of the input signal in a first operation, the first storage is performed so that the ratio between the capacitance of the front stage capacitance part and the capacitance of the feedback capacitance part is set to the predetermined capacitance ratio.

19. The A/D conversion method according to claim 16, wherein the operations are performed M times (M is an integer equal to or greater than 2), and
in the sampling step of the input signal in second to (M-1)_th operations, the second storage is performed so that the ratio between the capacitance of the front stage capacitance part and the capacitance of the feedback capacitance part is set to a capacitance ratio that is smaller than the predetermined capacitance ratio in the first storage.

20. The A/D conversion method according to claim 16, wherein the operations are performed M times (M is an integer equal to or greater than 2),

in the sampling of the input signal in second to (M-1)_th operations, the number of the front stage capacitors that store the analog signal in the second storage is set to 2 or more, so that the ratio between the capacitance of the front stage capacitance part and the capacitance of the feedback capacitance part is set to a first capacitance ratio that is smaller than the predetermined capacitance ratio in the first storage, and

in the sampling of the input signal in an M_th operation, the number of the front stage capacitors that store the analog signal in the second storage is set to 0 or 1, so that the ratio between the capacitance of the front stage capacitance part and the capacitance of the feedback capacitance part is set to a second capacitance ratio that is smaller than the first capacitance ratio.

Fig.1

# Fig.2

EP 4 742 541 A1

| Cycle: | (1) | (2) | | (M-1) | (M) |
|---|---|---|---|---|---|
| Gain: | 1.5 | 1.0 | | 1.0 | 0.5 |

| Phase: | P1A | P1B | P2A | P2B | · · · | P2A | P2B | P3A | P3B |
|---|---|---|---|---|---|---|---|---|---|

Fig.3

EP 4 742 541 A1

**Fig.4**

# Fig.5

Y1A

(a)

Y1B

(b)

Y1B

(c)

# Fig.6

EP 4 742 541 A1

EP 4 742 541 A1

# Fig.7

Cycle: (1) (2) (M-1) (M)

Gain: 1.75 1.0 1.0 0.25

Phase:

| P1A | P1B | P2A | P2B | · · · | P2A | P2B | P3A | P3B |

Fig.8

# Fig.9

(a)

(b)

(c)

**Fig.10**

34

| Cycle: | (1) | (2) | | (M-1) | (M) |
|--------|-----|-----|--|-------|-----|
| Gain: | 2.0 | 1.0 | | 1.0 | 0.0 |
| Phase: | P1A P1B | P2A P2B | · · · | P2A P2B | PNA PNB |

Fig.11

# Fig.12

(a)

| Cycle: | (1) | (2) | | (M) | (M+1) |
|---|---|---|---|---|---|

Gain to Vin:     0.5        1.0        1.0        0.5

Phase:   | P1A | P1B | P2A | P2B | · · · | P2A | P2B | P1A | P1B |

(b)

| Cycle: | (1) | (2) | | (M) | (M+1) |
|---|---|---|---|---|---|

Gain to Vin:     1.0        1.0        1.0        None

Phase:   | P1A | P1B | P1A | P1B | · · · | P1A | P1B | PNA | PNB |

EP 4 742 541 A1

# Fig.13

# *Fig.14*

(a)

(b)

# Fig.15

(a)

(b)

# Fig.16

(a)

(b)

## INTERNATIONAL SEARCH REPORT

| International application No. |
| --- |
| **PCT/JP2024/028142** |

**A. CLASSIFICATION OF SUBJECT MATTER**

*H03M 1/16*(2006.01)i; *H03M 1/08*(2006.01)i; *H03M 1/14*(2006.01)i
FI: H03M1/16 B; H03M1/08 A; H03M1/14 B

According to International Patent Classification (IPC) or to both national classification and IPC

**B. FIELDS SEARCHED**

Minimum documentation searched (classification system followed by classification symbols)

H03M1/16; H03M1/08; H03M1/14

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2017-201751 A (UNIV SHIZUOKA NAT UNIV CORP.) 09 November 2017 (2017-11-09) entire text, all drawings | 1-20 |
| A | JP 2017-17467 A (KABUSHIKI KAISHA TOSHIBA) 19 January 2017 (2017-01-19) entire text, all drawings | 1-20 |

☐ Further documents are listed in the continuation of Box C.    ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **27 September 2024** | **08 October 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

| International application No. |
| --- |
| **PCT/JP2024/028142** |

| Patent document cited in search report | | | Publication date (day/month/year) | Patent family member(s) | Publication date (day/month/year) |
| --- | --- | --- | --- | --- | --- |
| JP | 2017-201751 | A | 09 November 2017 | (Family: none) | |
| JP | 2017-17467 | A | 19 January 2017 | US 2017/0005667 A1 entire text, all drawings | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018088476 A
- JP 2017201751 A
- JP 2017139583 A
- WO 2012111821 A
- JP 2017055174 A
- JP 2007049637 A